# EUROPEAN PATENT APPLICATION

(11) **EP 1 557 871 A1**
(43) Date of publication of application: **27.07.2005**
(21) Application number: 03769903.0
(22) Date of filing: 15.10.2003
(51) Int. Cl.: H01L 21/205, C23C 16/50, H01L 31/04, H05H 1/46

(54) **THIN FILM FORMING APPARATUS AND THIN FILM FORMING METHOD AND THIN FILM FORMING SYSTEM**

(30) Priority: 18.10.2002 JP 2002304652
(71) Applicant: Ishikawajima-Harima Heavy Industries Co., Ltd., Chiyoda-ku, Tokyo 100-8182 (JP)
(72) Inventor: ITO, N., Ishikawajima-Harima Heavy Ind. Co., Ltd., Yokohama-shi, Kanagawa 235-8501 (JP); TAKAGI, T., Ishikawajima-Harima Heavy Ind. Co. Ltd, Yokohama-shi, Kanagawa 235-8501 (JP); UEDA, M., Ishikawajima-Harima Heavy Ind. Co., Ltd., Yokohama-shi, Kanagawa 235-8501 (JP)
(74) Representative: Lamb, Martin John Carstairs
(86) International application number: PCT/JP2003/013205
(87) International publication number: WO 2004/036634

(57) **Abstract**

Thin films are formed on substrates (300) disposed in a chamber (15) in a thin film forming device (6) by a plasma CVD method (chemical vapor deposition method).

A plurality of thin film forming regions 17u, 17v, and 17w, the regions having electrodes (40) for generating plasma, are disposed in the chamber (15). The thin film forming device (6) is provided with a power supply system (36) for supplying electric power to the electrodes (40), and a switching device 34 for connecting the power supply system (36) and the electrodes 40 disposed in each one of the thin film forming regions 17u, 17v, and 17w. By doing this, it is possible to provide a desirable power supply system, a gas supply system, and an pumping system. By adjusting an operation of the thin film forming device, the costs of the thin film forming device and the thin film forming system can be reduced without reducing production efficiency in steps for layering the thin films. Also, a thin film forming device, a thin film forming method, and a thin film forming system can be realized in which the power supply system can be simplified and space for installation thereof can be saved.

## Description

### TECHNICAL FIELD

The present invention relates to a thin film forming device, a method for forming thin films, and a thin film forming system.

### BACKGROUND ART

Conventional thin film solar cells consist of p-i-n junction-type semi-conductor thin films, i.e., silicon, compound semiconductors, and the like, formed on transparent substrates.

In order to form the above semiconductor thin film, a plasma CVD method (Chemical Vapor Deposition method) has been proposed, in which material gas is under plasma state by supplying electric power to electrodes in a thin film forming system, the material gas in plasma state is excited and decomposed to be a precursor. The precursors are deposited on the substrates by surface reaction.

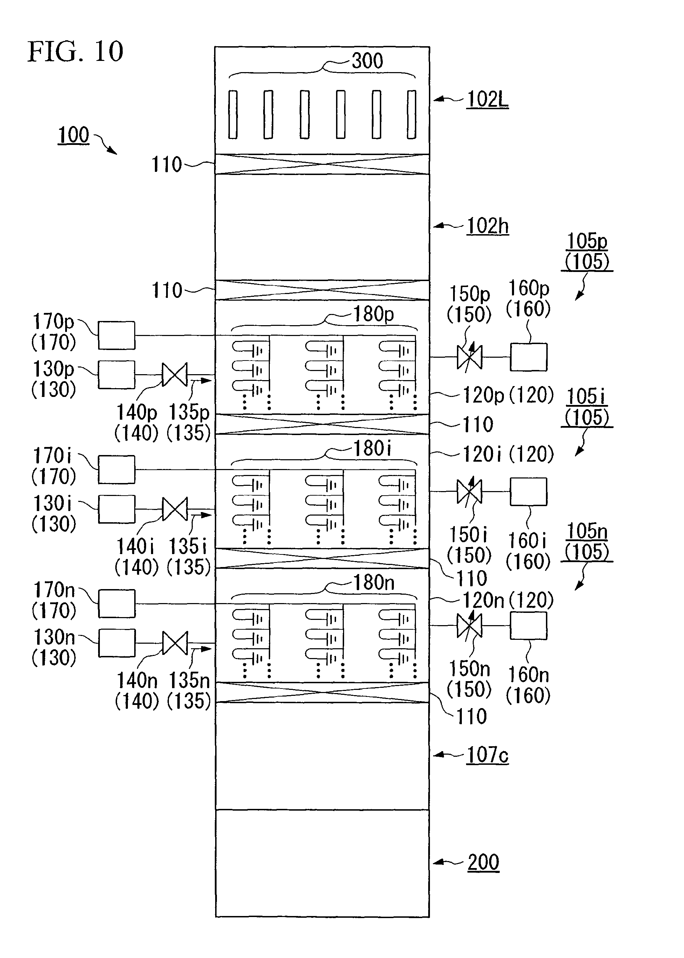

FIG. 10 shows a thin film forming system for inline solar cells as an example for a system for forming the above semiconductor thin films. A thin film forming system 100 consists of a load-lock device 102L for evacuating air around the substrates so that the substrates are in vacuum state, a heating device 102h for heating the substrates, thin film forming devices 105p, 105i, and 105n, respectively forming p-type semiconductors, i-type semiconductors, and n-type semiconductors, a cooling device 107c for cooling the substrates, and gate valves 110 disposed among the devices.

In each of the thin film forming devices 105p, 105i, and 105n, there are provided chambers 120p, 120i, and 120n, gas boxes 130p, 130i, and 130n, material gas supply valves 140p, 140i, 140n, pressure-adjusting valves 150p, 150i, and 150n, vacuum pumps 160p, 160i, 160n, power supply systems 170p, 170i, and 170n, and electrodes 180p, 180i, and 180n.

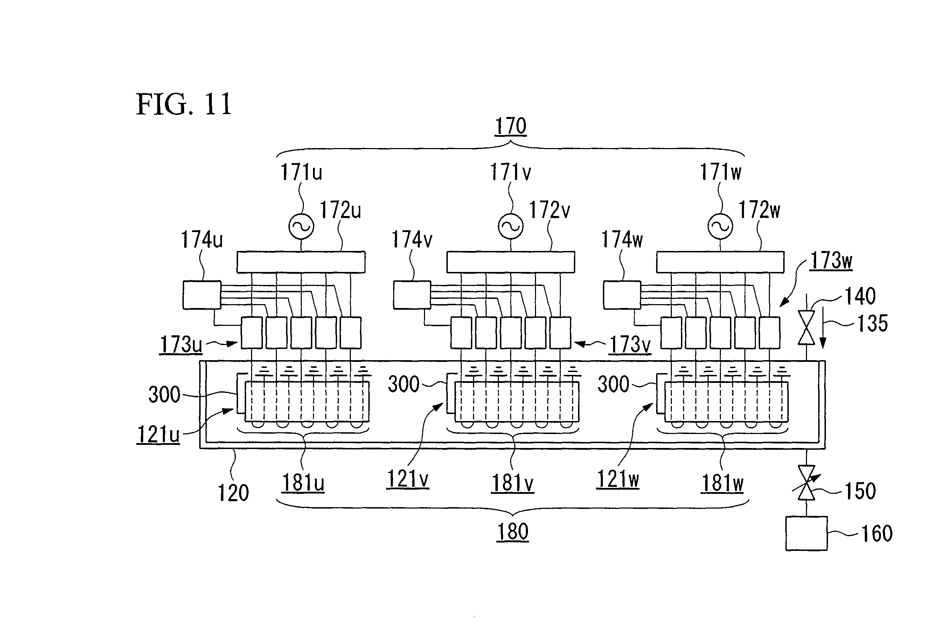

FIG. 11 is a schematic diagram showing the chambers 120 (120p, 120i, 120n), the power supply systems 170 (170p, 170i, 170n), and the electrodes 180 (180p, 180i, 180n) in detail. In the chambers 120, there are provided thin film forming regions 121u, 121v, and 121w for forming the thin films on the substrates 300. In each of the thin film forming regions, there are provided high frequency power supplies 171u, 171v, and 171w, dividers 172u, 172v, and 172w, circulators 173u, 173v, and 173w, dummy loads 174u, 174v, and 174w, and plural sets of electrodes 181u, 181v, and 181w.

In the thin film forming system 100, the substrates 300, on which the thin films are formed, are disposed perpendicularly to the plane of FIG. 10 such that the substrates 300 are transported by transporting devices, not shown in the drawing, in order, to the load-lock device 102L, the heating device 102h, the thin film forming device s105p, the thin film forming device 105i, the thin film forming device 105n, and the cooling device 107c.

The substrates 300 and plural sets of the electrodes 181u, 181v, and 181w are disposed perpendicularly to the plane of FIG. 11 similarly to in FIG. 10. However, in FIG. 11, for better understanding the operation of the thin film forming system 100, the substrates and the electrodes are disposed horizontally to the plane of the drawing.

In this thin film forming system 100, the transporting devices, not shown in the drawing, transport a plurality of the substrates 300 to the load-lock device 102L under an atmospheric condition, and after that, pressure around the substrates 300 is decompressed until all the air in the load-lock device 102L is evacuated. After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h. The substrates 300, disposed in the heating device 102h, are heated to a predetermined temperature by the heating device 102h.

Afterward, the gate valve 110, disposed between the heating device 102h and the thin film forming device 105p, opens, and the transporting devices, not shown in the drawing, transport the substrates 300 from the heating device 102h to the thin film forming device 105p; thus, the substrates 300 are disposed in the thin film forming device 105p. An inside of the thin film forming device 105p is maintained under a vacuum condition by the vacuum pump 160p so as to be ready to start forming the thin films on the substrates 300.

In order to form the thin films on the substrates 300 which are disposed in the thin film forming device 105p, material gas 135p is supplied from the gas box 130p to the chamber 120p, and a pressure in the chamber 120p is adjusted by the pressure-adjusting valve 150p.

Electric power from the high frequency power supplies 171u, 171v, and 171w in the power supply system 170p (170) is supplied to the dividers 172u, 172v, and 172w respectively. The electric power is further divided to the circulators 173u, 173v, and 173w by the dividers 172u, 172v, and the 172w, and further, the electric power is supplied to the electrodes 181u, 181v, and 181w via the circulators 173u, 173v, and 173w. A portion of the electric power, supplied to the electrodes 181u, 181v, and 181w, is reflected as a reflection wave. The reflected wave is transmitted to the dummy loads 174u, 174v, and 174w via the circulators 173u, 173v, and 173w, and thereby, exhausted as heat.

The material gas 135p is plasmatized by the electric power supplied to the plural sets of electrodes 181u, 181v, and 181w. The material gas in plasma state is excited and decomposed to be a precursor. The precursors are deposited on the substrates 300 by surface reaction. Thus, p-type semiconductor thin films are formed on the substrates 300.

The p-type semiconductor thin films are formed in the thin film forming regions 121u, 121v, and 121w simultaneously.

Next, the gate valve 110, disposed between the thin film forming devices 105p and 105i, opens, and the transporting devices, not shown in the drawing, transport the substrates 300 from the thin film forming device 105p to the thin film forming device 105i; thus, the substrates 300 are disposed in the thin film forming device 105i. An inside of the thin film forming device 105i is maintained under a vacuum condition by the vacuum pump 160i so as to be ready to start forming the thin films on the substrates 300.

Similarly to in the operations for forming the thin films in the above thin film forming device 105p, the material gas 135i is supplied from the gas box 130i to the chamber 120i. The electric power is supplied from the power supply system 170i (170) to the electrodes 181u, 181v, and 181w under the condition that a pressure inside the chamber 120i is adjusted by the pressure-adjusting valve 150i. By a chemical reaction for forming the thin films there, i-type semiconductor thin films are formed on the substrates 300.

The i-type semiconductor thin films are formed in the thin film forming regions 121u, 121v, and 121w simultaneously.

Next, the gate valve 110, disposed between the thin film forming devices 105i and 105n, opens, and the transporting devices, not shown in the drawing, transport the substrates 300 from the thin film forming device 105i to the thin film forming device 105n; thus, the substrates 300 are disposed in the thin film forming device 105n. An inside of the thin film forming device 105n is maintained under a vacuum condition by the vacuum pump 160n so as to be ready to start forming the thin films on the substrates 300.

Similarly to in the operations for forming the thin films in the above thin film forming devices 105p and 105i, the material gas 135n is supplied from the gas box 130n to the chamber 120n. The electric power is supplied from the power supply system 170n (170) to the electrodes 181u, 181v, and 181w under the condition that a pressure inside the chamber 120n is adjusted by the pressure-adjusting valve 150n. By a chemical reaction for forming the thin films there, n-type semiconductor thin films are formed on the substrates 300.

The n-type semiconductor thin films are formed in the thin film forming regions 121 u, 121 v, and 121w simultaneously.

In the above operations for forming the thin films, any one of p-type, i-type, and n-type semiconductor thin film can be selectively stacked by changing the material gas 135 (135p, 135i, and 135n). By forming the semiconductor thin films in the above explained manner, p-i-n junction semiconductor thin films are formed.

After the p-i-n junction semiconductor thin films are formed on the substrates 300, the gate valve 110, disposed between the thin film forming device 105n and the cooling device 107c, opens, and the transporting devices, not shown in the drawing, transport the substrates 300 from the thin film forming device 105n to the cooling device 107c; thus, the substrates 300 are disposed in the cooling device 107c.

The substrates 300 disposed in the cooling device 107c are cooled to a predetermined temperature, and after that, the transporting devices, not shown in the drawing, transport the substrates 300 to an unload-lock device 200. Pressure in a vacuum space in the unload-lock device 200 is pressurized to an atmospheric pressure.

In order to produce amorphous silicon solar cells by the thin film forming system 100, times for forming the thin films, i.e., p-type semiconductor thin films, i-type semiconductor thin films, and n-type semiconductor thin films are approximately, 2 minutes, 20 minutes, and 2 minutes respectively. The times for forming the p-type and the n-type semiconductor thin films are shorter than that of the i-type semiconductor thin films; therefore, the substrates 300, on which the p-type semiconductor thin films are formed, stand by during formulation of the i-type semiconductor thin films. Also, after the substrates 300, on which the n-type semiconductor thin films are formed, are transported to the cooling device 107c, the thin film forming device 105n stands by until the i-type semiconductor thin films are formed on the substrates 300.

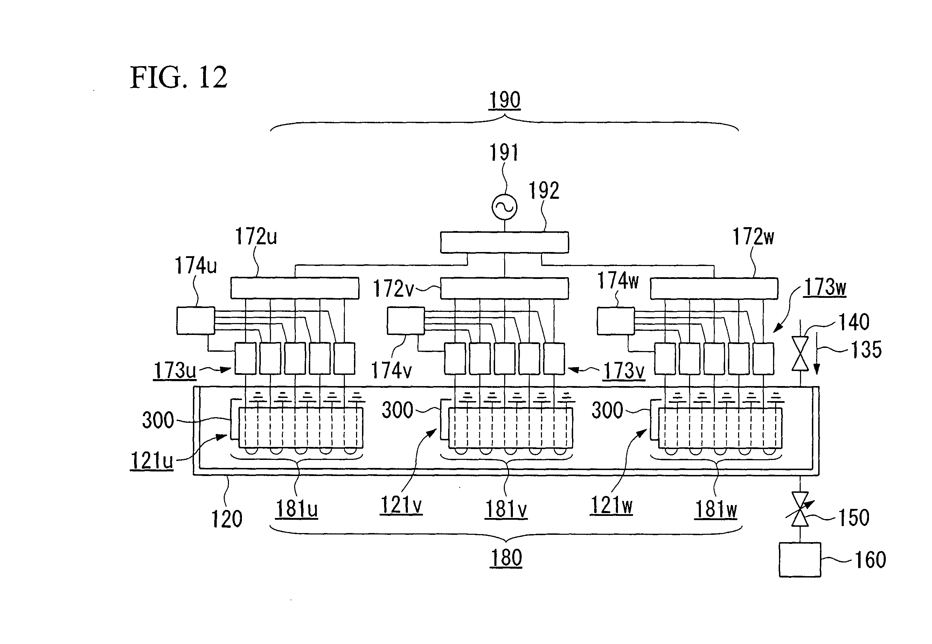

The above p-i-n junction semiconductor thin films are formed in an inline-type thin film forming system which is provided with a power supply system 190 as shown in FIG. 12. In order to replace the power supply system 170, the power supply system 190 supplies the electric power to the thin film forming devices 105p, 105i, and 105n. More specifically, a common high frequency power supply 191 and a common divider 192 are provided to input sides for each one of the dividers 172u, 172v, and 172w.

The substrates 300 and the electrodes 181 u, 181 v, and 181 ware disposed perpendicularly to the plane of FIG. 12 similarly to in the FIG. 10. However, in FIG. 11, for better understanding the operation of the thin film forming system 100, the substrates and the electrodes are disposed horizontally to the plane of the drawing.

Similarly to in the thin film forming system 100, in the thin film forming system which is provided with the power supply system 190, the transporting devices, not shown in the drawing, transport a plurality of the substrates 300 to the load-lock device 102L under an atmospheric condition, and after that, pressure around the substrates 300 is decompressed until all the air in the load-lock device 102L is evacuated. After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h. The substrates 300, disposed in the heating device 102h, are heated to a predetermined temperature by the heating device 102h.

Next, the gate valve 110, disposed between the heating device 102h and the thin film forming device 105p, opens, and the transporting devices, not shown in the drawing, transport the substrates 300 from the heating device 102h to the thin film forming device 105p; thus, the substrates 300 are disposed in the thin film forming device 105p. An inside of the thin film forming device 105p is maintained under a vacuum condition by the vacuum pump 160p so as to be ready to start forming the thin films on the substrates 300.

In order to form the thin films on the substrates 300 which are disposed in the thin film forming device 105p, material gas 135p is supplied from the gas box 130p to the chamber 120p, and pressure in the thin film forming device 105p is adjusted by the pressure-adjusting valve 150p.

Furthermore, electric power is supplied from the common high frequency power supply 191 in the power supply system 190 to the common divider 192. The electric power is divided to the dividers 172u, 172v, and 172w by the common divider 192, and each portion of the divided electric power is further distributed to the circulators 173u, 173v, and 173w. The portions of electric power, which are distributed from the circulators 173u, 173v, and 173w, are supplied to the plural sets of the electrodes 181u, 181v, and 181w. A portion of the electric power, supplied to the plural sets of electrodes 181u, 181v, and 181w, is reflected as a reflection wave. The reflected wave is transmitted to the dummy loads 174u, 174v, and 174w via the circulators 173u, 173v, and 173w, and thereby, exhausted as heat.

The material gas 135p is plasmatized by the electric power supplied to the plural sets of electrodes 181u, 181v, and 181w. The material gas in plasma state excited and decomposed to be a precursor. The precursors are deposited on the substrates 300 by surface reaction. Thus, p-type semiconductor thin films are formed on the substrates 300.

The p-type semiconductor thin films are formed in the thin film forming regions 121u, 121v, and 121w simultaneously.

Next, the gate valve 110, disposed between the thin film forming devices 105p and 105i, opens, and the transporting devices, not shown in the drawing, transport the substrates 300 from the thin film forming device 105p to the thin film forming device 105i; thus, the substrates 300 are disposed in the thin film forming device 105i. An inside of the thin film forming device 105i is maintained under a vacuum condition by the vacuum pump 160i so as to be ready to start forming the thin films on the substrates 300.

Similarly to in the operations for forming the thin films in the above thin film forming device 105p, the material gas 135i is supplied from the gas box 130i to the chamber 120i. Electric power is supplied from the power supply system 190 to the electrodes 181u, 181v, and 181w under the condition that pressure inside the chamber 120i is adjusted by the pressure-adjusting valve 150i. By a chemical reaction for forming the thin films there, the i-type semiconductor thin films are formed on the substrates 300.

The i-type semiconductor thin films are formed in the thin film forming regions 121u, 121v, and 121w simultaneously.

The gate valve 110, disposed between the thin film forming devices 105i and 105n, opens, and the transporting devices, not shown in the drawing, transport the substrates 300 from the thin film forming device 105i to the thin film forming device 105n; thus, the substrates 300 are disposed in the thin film forming device 105n. An inside of the thin film forming device 105n is maintained under a vacuum condition by the vacuum pump 160n so as to be ready to start forming the thin films on the substrates 300.

Similarly to in the operations for forming the thin films in the above thin film forming devices 105p and 105i, the material gas 135n is supplied from the gas box 130n to the chamber 120n. Electric power is supplied from the power supply system 190 to the electrodes 181u, 181v, and 181w under the condition that pressure inside the chamber 120n is adjusted by the pressure-adjusting valve 150n. By a chemical reaction for forming the thin films there, n-type semiconductor thin films are formed on the substrates 300.

The n-type semiconductor thin films are formed in the thin film forming regions 121u, 121v, and 121w simultaneously.

In the above operations for forming the thin films, any one of p-type, i-type, or n-type semiconductor thin film can be selectively disposed by changing the material gas 135 (135p, 135i, and 135n). By forming the semiconductor thin films in the above explained manner, p-i-n-junction semiconductor thin films are formed.

After the p-i-n junction semiconductor thin films are formed on the substrates 300, the gate valve 110, disposed between the thin film forming device 105n and the cooling device 107c, opens, and the transporting devices, not shown in the drawing, transport the substrates 300 from the thin film forming device 105n to the cooling device 107c; thus, the substrates 300 are disposed in the cooling device 107c.

The substrates 300 disposed in the cooling device 107c are cooled to a predetermined temperature, and after that, the transporting devices, not shown in the drawing, transport the substrates 300 to an unload-lock device, not shown in the drawing. Pressure in a vacuum space in the unload-lock device 200 is pressurized to atmospheric pressure.

The time for forming the amorphous silicon solar cells by the thin film forming system provided with the power supply system 190 is approximately the same as the time for forming the thin films by the thin film forming system 100; therefore, the substrates 300, on which the p-type semiconductor thin films are formed, stand by during formulation of the i-type semiconductor thin films. Also, after the substrates 300, on which the n-type semiconductor thin films are formed, are transported to the cooling device 107c, the thin film forming device 105n stands by until the i-type semiconductor thin films are formed on the substrates 300.

Also, in this thin film forming system provided with the power supply system 190, the necessary quantity of the high frequency power supplies is less than that with the above power supply system 170.

However, in the above conventional thin film forming device and the conventional thin film forming system, the power supply system 170 must be provided with the high frequency power supplies 171u, 171v, and 171w, the dividers 172u, 172v, and 172w, the circulators 173u, 173v, and 173w, and the dummy loads 231, 232, and 233, respectively corresponding to the thin film forming regions 121u, 121v, and 121w in the thin film forming devices 105 (105p, 105i, and 105n). Therefore, the schematic diagram for the power supply system 105 was inevitably complicated; thus, there are problems in that, the power supply system 170 needs a larger area for its installation, and costs for the thin film forming devices 105 (105p, 105i, and 105n) and the thin film forming system 100 increase.

Also, in order to avoid these problems, if the necessary quantity of the high frequency power supplies in the power supply system 190 is decreased, the common high frequency power supply 191 must be capable of supplying a great deal of power. As a result, there was a problem in that it was not possible to reduce the cost of the thin film forming system 100.

Also, the thin films are formed in the thin film forming regions 121u, 121v, and 121w simultaneously; therefore, the vacuum pumps 160 (160p, 160i, and 160n) must be capable of pumping the material gases 135 (135p, 135i, and 135n), which are supplied to the thin film forming regions 121u, 121v, and 121w, more efficiently. Thus, there was a problem in that the cost of the vacuum pumps increased.

Also, in any of the thin film forming devices and any of the thin film forming systems, the time for forming the i-type semiconductor thin films is longer than that of the p-type and the n-type semiconductor thin films. That is, the operation for forming the i-type semiconductor thin films is one of important factors for determining throughput for manufacturing the solar cells. Therefore, there was a problem in that the operations for forming the p-type semiconductor thin films and the n-type semiconductor thin films in the thin film forming devices 105p and 105n had to stand by until the formation of the i-type semiconductor thin films was completed.

### DISCLOSURE OF THE INVENTION

The present invention was conceived in view of the above circumstances, and an object thereof is to provide power supply systems in which high-cost power supply systems and high-power high frequency power supplies are not necessary, and gas supply systems for supplying material gasses in accordance with thin film forming regions in each of which the thin films are formed, and pumping systems in each of which vacuum pumps having lower pumping speeds are provided. Another object thereof is to reduce costs of a thin film forming device and a thin film forming system, by forming the thin films with reference to an operation having the longest time for forming the thin films and arranging the rest of the operations so that a production efficiency for forming layered thin films is not affected. An other object thereof is to provide a space-saving thin film forming device, a space-saving thin film forming method, and a space-saving thin film forming system which enable simpler power supply systems.

If there is a description "at least one, but not all of the electrodes" in the present specification, it means that "an arbitrary selected number of the electrodes representing at least one but not all of the electrodes." "Selected electrodes" has the same meaning.

In order to achieve the above objects, the present invention proposes devices and methods as below.

A first invention provides a thin film forming device for forming thin films on substrates disposed in chambers by a plasma CVD method (Chemical Vapor Disposition method) is proposed, including a plurality of thin film forming regions, disposed in the chambers, having electrodes for generating plasma; a section for limiting one of the thin film forming regions in which electric power is supplied to at least one, but not all of the electrodes, simultaneously; and gas supply systems for supplying material gases for generating plasma in the thin film forming regions.

According to the above thin film forming device, the thin film forming regions are in which the electric power is supplied to, are limited to at least one, but not all of the electrodes under the condition that the substrates are disposed in the thin film forming regions in the chambers. The material gases for generating the plasma are supplied to the limited regions, and thereby, the electric power is supplied to the electrodes disposed in the limited regions. The material gases are excited and decomposed in the thin film forming regions. By a chemical reaction for forming the thin films on the substrates, the thin films are formed on the substrates.

After the thin films are formed on the substrates in the thin film forming regions, the gas supply systems supply the material gases to the limited thin film forming regions in which the thin films are not yet formed on the substrates; thus, the thin films are formed on the substrates similarly to in the above operation. The thin films are formed in a plurality of thin film forming regions in the chambers similarly. After the thin films are formed on the substrates in all of the thin film forming regions, the operations for forming the thin films in the chambers are completed.

After the completion of the formation of the thin films, the substrates are transported to chambers in which thin films different from the above thin films are formed. In the chambers for forming the different thin films, the different thin films are formed on the substrates; thus, the thin films are layered on the substrates.

The substrates are transported into chambers, in each of which new thin films are formed, step by step; thus, different thin films are layered on the substrates. By doing this, desirable layered thin films are formed on the substrates.

The thin films are formed in the above manner through all the steps for forming the layered thin films except the steps which is one of important factors for determining the throughput. By doing this, it is possible to shorten a time for standing by the completion of the formation of the thin films in the throughput determining steps.

The thin films are formed by supplying the material gases by, at first, limiting the thin film forming regions by the gas supply systems, and after that, by supplying the material gases while limiting the thin film forming regions in which the thin films are about to be formed on the substrates. By doing this, the thin films can be formed by less flow rate of the material gases than those used in the case of the formation of the thin films in all of the thin film forming regions simultaneously.

That is, the thin films can be formed by using vacuum pumps, each of which has lower pumping speed than those used for forming the thin films in all of the thin film forming regions simultaneously. Therefore, it is possible to use smaller vacuum pumps; thus, it is possible to reduce the costs for the device.

Also, only a time for standing by the throughput determining step, on which the production efficiency depends, is shortened; therefore, the steps for layering the different thin films on the substrates are not delayed.

A second invention provides a thin film forming device for forming thin films on substrates disposed in chambers by a plasma CVD method (Chemical Vapor Disposition method), including: a plurality of thin film forming regions, disposed in the chambers, having electrodes for generating plasma; power supply systems for supplying electric power to the electrodes, the electric power being controlled to be supplied to, at least one, but not all of the electrodes, the quantity of the power supply systems being less than the quantity of the thin film forming regions; and switching sections for connecting the electrodes in each one of the thin film forming regions selectively to the power supply system.

In the above thin film forming device according to the present invention, the switching devices connect the electrodes to the power supply systems selectively, and the power supply systems supply the electric power to at least one, but not all of the electrodes, under the condition that the substrates are disposed in the thin film forming regions in the chambers, and that the material gases are supplied to the chambers. The material gases are excited and decomposed in the thin film forming regions, in which the electric power is supplied to the electrodes therein. By a chemical reaction for forming the thin films on the substrates, the thin films are formed on the substrates.

When the thin films are formed on the substrates in the thin film forming regions, the switching devices select the electrodes which belong to the thin film forming regions having the substrates on which the thin films are about to be formed, and connect the selected electrodes to the power supply systems. Similarly to in the above explanation, the thin films are formed under the condition that the power supply systems supply the electric power to the electrodes. The thin films are formed in a plurality of thin film forming regions in the chambers similarly. After the thin films are formed on the substrates in all of the thin film forming regions, the operations for forming the thin films in the chambers are completed.

After the completion of the formation of the thin films, the substrates are transported to chambers in which thin films different from the above thin films are formed. In the chambers for forming the different thin films, the different thin films are formed on the substrates; thus, the thin films are layered on the substrates.

The substrates are transported into chambers, in each of which thin films different from each other are formed, step by step; thus, different thin films are layered on the substrates. By doing this, desirable layered thin films are formed on the substrates.

The thin films are formed in the above manner through all the steps for forming the layered thin films except the steps which is one of important factors for throughput. By doing this, it is possible to shorten a time for standing by the completion of the formation of the thin films in the throughput determining step.

The thin films are formed, at first, by connecting the power supply systems and the electrodes selectively by the switching devices and supplying the electric power to the electrodes by the power supply systems, and after that, by supplying the electric power to the electrodes in the thin film forming regions in which the thin films are about to be formed on the substrates. By doing this, in the present invention, it is possible to use power supply systems having smaller power outputs than the power supply systems which supply the electric power to all of the thin film forming regions in the chambers simultaneously.

That is, the cost for the power supply systems can be reduced, space for installing the power supply systems can be saved, and the cost for the thin film forming device can be reduced.

Also, the time for standing by the throughput determining step, on which production efficiency depends, is shortened; therefore, the steps for layering the thin films on the substrates are not delayed.

Also, in the second invention, the thin film forming device may be provided with gas supply systems for supplying the material gases for generating plasma in the thin film forming regions while limiting the thin film forming regions in which the electric power is supplied to the electrodes therein.

In the thin film forming device according to the present invention, the switching devices connect the power supply systems to the electrodes selectively, and the power supply systems supply the electric power to the electrodes. In addition, the gas supply systems supply the material gases for generating plasma while limiting the thin film forming regions, in which the thin films are about to be formed. In the thin film forming regions to which the electric power and the gases are supplied, the material gases are plasmatized. The plasmatized gases are excited and decomposed. By a chemical reaction for forming the thin films on the substrates, the thin films are formed on the substrates.

Further to the above invention, the thin films are formed by supplying the material gases while the thin film forming regions are limited. Therefore, the material gases are not supplied to unnecessary thin film forming regions in which the plasma are not produced. Thus, efficiency for gas usage can be improved, and the thin films can be formed by less flow rate of the material gases than in the case of the material gases which are supplied to all of the thin film forming regions simultaneously.

That is, the thin films can be formed by using vacuum pumps, each of which has lower pumping speed than those used for forming the thin films in all of the thin film forming regions simultaneously. Therefore, it is possible to use smaller vacuum pumps; thus, it is possible to reduce not only the cost of the power supply systems, but also the cost of the device.

Also, in the second invention, the thin film forming device may be provided with array-antennas, as the electrodes, for generating plasma.

In the present invention, the thin film forming device has an array-antenna structure, in which a plurality of antennas for generating plasma are disposed in each of the thin film forming regions disposed in the chambers.

Therefore, further to the above invention, the material gases are excited and decomposed by the electric power supplied from the array-antennas. By a chemical reaction for forming the thin films on the substrates, uniform thin films can be formed on the substrates.

The details of the array-antennas are explained in "Internal electrode type plasma processing apparatus and plasma processing method", International Patent Application No. PCT/JP00/06189.

Also, in the second invention, barrier plates may be disposed on borders between the thin film forming regions, the barrier plates preventing the material gases from diffusing from one of the thin film forming regions in which the thin films are being formed to another one of the thin film forming regions, in which the thin films are not formed.

In the thin film forming device according to the present invention, the barrier plates are disposed on the borders between the thin film forming regions: therefore, the material gases plasmatized by the electric power supplied to the electrodes, i.e., the above array-antennas, the and excited and decomposed are restricted from diffusing to the thin film forming regions in which the thin films are not formed.

That is, the thin films are formed on the substrates which are disposed in the thin film forming regions, to which the electrodes, i.e., the above array-antennas, belong.

Also, in the second invention of the thin film forming device, each of the thin film forming regions may be provided in independent spaces, sealed from each other.

In the thin film forming device according to the present invention, the thin film forming regions are the independent spaces, sealed from each other; therefore, the material gas, excited and decomposed in each of the independent spaces is layered so as to form the thin films on the substrates disposed in each of the independent spaces. Accordingly, the material gases are restricted from diffusing to the other independent spaces; thus, the material gases do not form the thin films on the substrates in the other independent spaces.

Furthermore, unnecessary elements, generated during the formation of the thin films, are restricted from diffusing; thus, the unnecessary elements do not diffuse into the independent spaces.

Also, in the thin film forming device, having the independent spaces, according to the second invention, may be provided with pumping sections for pumping the gases in the chambers. In addition, each of the pumping sections may be provided with pumping block valves for blocking the gas from at least one of the thin film forming regions.

In the thin film forming device according to the present invention, the thin film forming regions are the independent spaces, sealed from each other, and each of the thin film forming regions is provided with pumping block valves for blocking the gas from at least one of the thin film forming regions. Therefore, the gases in the independent spaces can be pumped efficiently by closing the pumping block valves in the independent spaces having gases not needing to be pumped, and by opening the pumping block valves in the independent spaces having gases needing to be pumped. Also, it is possible to maintain the independent spaces under a vacuum condition.

If one of the independent spaces is not operable, and maintenance is necessary, the inoperable independent space can be repaired under an atmospheric condition, by closing the pumping block valve of the inoperable independent space, while the rest of the independent spaces are under a vacuum condition.

Also, in the first and second inventions, the thin film forming device may be provided with transporting systems for transporting the substrates into only one of the thin film forming regions and transporting the substrates from the thin film forming region after the formation of the thin films.

In the thin film forming device according to the present invention, desirable thin films are formed on the substrates by the above operation, it is not necessary to transport the substrates to one of the thin film forming regions to another in the same chamber; thus, it is not necessary to form the thin films again in a new chamber. Accordingly, the substrates are transported from the thin film forming region to outside of the chamber, and various processes are conducted to the substrates, i.e., next thin films are formed on the substrates. That is, the substrates, on which the desirable thin films are formed, can be transported efficiently by the transporting systems.

Also, in the first and second invention, the thin film forming device may be provided with importing sections for transporting the substrates into the thin film forming region; and exporting sections for transporting the substrates after the formation of the thin films, the exporting sections being different from the importing sections.

In the thin film forming device according to the present invention, the substrates, transported by the importing sections to the thin film forming region and having the thin films thereon, are transported by the exporting sections, without returning to the importing sections. That is, the transportation of the substrates is not reciprocal. Therefore, the substrates, having the thin films thereon, can be transported efficiently.

A third invention is a method for forming thin films on substrates disposed in chambers by plasma CVD method (Chemical Vapor Disposition method), including: selecting at least one electrode disposed in each one of thin film forming regions by switching sections so that all of the electrodes are not selected; connecting the selected electrodes to power supply systems; and supplying electric power from the power supply systems to the electrodes selected by the switching sections.

In the above method for forming the thin films according to the present invention, the switching devices connect the electrodes to the power supply systems selectively, and the power supply systems supply the electric power to at least one, but not all of the electrodes, under the condition that the substrates are disposed in the thin film forming regions in the chambers, and that the material gases are supplied to the chambers. The material gases are excited and decomposed in the thin film forming regions, in which the electric power is supplied to the electrodes therein. By a chemical reaction for forming the thin films on the substrates, the thin films are formed on the substrates.

After that, the switching devices select the electrodes, which belong to the thin film forming regions having the substrates on which the thin films are not formed, and connect the selected electrodes to the power supply systems. Similarly to in the above explanation, the thin films are formed under the condition that the power supply systems supply the electric power to the electrodes. The thin films are formed in a plurality of thin film forming regions in the chambers similarly. After the thin films are formed on the substrates in all of the thin film forming regions, the operations for forming the thin films in the chambers are completed.

The thin films are formed, at first, by connecting the power supply systems and the electrodes selectively by the switching devices and supplying the electric power to the electrodes from the power supply systems, and after that, by supplying the electric current to the electrodes in the thin film forming regions in which the thin films are about to be formed on the substrates. By doing this, in the present invention, it is possible to use power supply systems having smaller power outputs than power supply systems which supply the electric power to all of the thin film forming regions in the chambers simultaneously.

That is, the power supply systems can be simplified, space for installing the power supply systems can be saved, and the cost for the thin film forming device can be reduced.

Also, according to the third invention, the thin film forming method may include: limiting to at least one of the thin film forming regions in which electric power is supplied to the electrodes; and supplying material gases for generating plasma to the limited thin film forming regions.

In the thin film forming device according to the present invention, the switching devices connect the power supply systems to the electrodes selectively, and the power supply systems supply the electric power to the electrodes. In addition, the gas supply systems supply the material gases for generating plasma while limiting the thin film forming regions, in which the thin films are about to be formed. The material gases are excited and decomposed in the thin film forming regions, to which the electric power and the gases are supplied. By a chemical reaction for forming the thin films on the substrates, the thin films are formed on the substrates.

Further to the above invention, the thin films are formed by supplying the material gases while the thin film forming regions are limited. Therefore, the material gases are not supplied to thin film forming regions in which the plasma is not produced. Thus, efficiency for gas usage can be improved, and the thin films can be formed by a less amount of the material gas than in the case of the material gas which is supplied to all of the thin film forming regions simultaneously.

That is, the thin films can be formed by using vacuum pumps, each of which has lower pumping speed than those used for forming the thin films in all of the thin film forming regions simultaneously. Therefore, it is possible to use smaller vacuum pumps; thus, it is possible to reduce not only the cost of the power supply systems, but also the cost of the device.

Also, in the third invention, the substrates, transported by the importing sections, may be transported by the exporting sections, different from the importing sections, after the formation of the thin films.

In the present invention, according to the thin film forming method, the substrates, transported by the importing sections to the thin film forming region and having the thin films thereon, are transported by the exporting sections, without returning to the importing sections. That is, the transportation of the substrates is not reciprocal. Therefore, the substrates, having the thin films thereon, can be transported efficiently.

A fourth invention is a thin film forming system for layering thin films on a plurality of substrates via a plurality of thin film forming devices, in which each one of a plurality of the thin film forming devices consists of a reference device, having the longest time for forming the thin films, and adjusting devices different from the reference device, the adjusting devices being the thin film forming device according to any one of the above explained inventions.

In the thin film forming system according to the present invention, the thin film forming devices are connected, in a line, having connecting sections, substrate importing sections, and substrate exporting sections, and the transporting systems transport the substrates among these sections.

The transporting system, disposed in the substrate importing section, transports the substrates into a first thin film forming device, and the transporting system, disposed in the connecting section, transports the substrates from the first thin film forming device after the formation of the thin films on the substrates in the first thin film forming device. The substrates are transported to a next thin film forming device; thus, plural types of thin films are formed on the substrates.

After that, plural types of thin films are formed on the substrates by transporting the substrates through the thin film forming devices. In the end, the transporting system in the substrate exporting section transports the substrates; thus, the formation of the thin films on the substrates is completed.

A time for forming the thin films varies in accordance with a type of the thin films, thickness of the thin films, and other conditions for forming the thin films. The thin film forming device, having the longest time for forming the thin films, is called a reference device. The rest of the thin film forming devices are called adjusting devices. The adjusting devices are the thin film forming devices which are explained above.

Next, explanations are given for one case in which the adjusting devices are conventional thin film forming devices, and another case, in which the adjusting devices are the thin film forming devices according to the above explained inventions. In addition, features of the present invention are explained.

If the adjusting devices are conventional thin film forming devices, the substrates are stacked in one of the adjusting devices, disposed ahead of the reference device, during the formation of the thin films in the reference device. Also, another adjusting device, disposed behind the reference device, must stand by the formation of the thin films. That is, each one of the adjusting devices is in a suspended state.

In contrast, if the adjusting devices are the thin film forming devices according to the above explained inventions, the thin films can be formed in each of the thin film forming regions in the stand-by time during the suspended state, by using the switching devices, or by the gas supply systems. By doing this, production delays do not occur in the series of the steps for layering the thin films, production cost can be reduced compared to with the thin film forming devices, in which the thin films are formed in all the thin film forming regions simultaneously, and the cost of the entire thin film forming system can be reduced.

In the fourth invention, the adjusting devices are operated in accordance with the time for forming the thin films in the reference device.

In the adjusting devices in the thin film forming system according to the present invention, the switching devices, or the gas supply systems, are operated such that production cost per time and area is moved toward a minimum.

More specifically, the costs of the power supply systems, the material gases, and the like, are reduced by adjusting the operation of the switching devices or the gas supply systems, each of the devices disposed in the adjusting devices. Thus, the cost of the thin film forming system is determined. Also, processing capacity in the thin film forming system is determined based on the time for forming the thin films in the adjusting devices or the reference device. In the adjusting devices, the switching devices, or the gas supply systems, are operated such that production cost of the thin film forming system, with respect to time and area, is moved toward a minimum, the time and area being calculated based on the cost of the device, and the processing capacity thereof.

If a relationship T ≥ nt is satisfied, under the conditions that T indicates a processing time in the reference device, n indicates a quantity of the thin film forming regions, and t indicates a processing time in each of the thin film forming regions in the adjusting devices, the above production cost can be reduced without decreasing a total processing capacity. Even if a relationship T<nt is satisfied, the above production cost can be reduced in the end.

Also, in the adjusting devices, by adjusting the operations of the switching devices and the gas supply systems, it is possible to employ power supply systems having desirable electric capacity and vacuum pumps having a desirable pumping speed. By doing this, the cost of the entire thin film forming system can be reduced.

Also, the fourth invention provides a thin film forming system for forming layered solar cells made of p-type, i-type, and n-type semiconductor thin films, including the adjusting device, the reference device, and another adjusting device disposed in that order. In the fourth invention, it is preferable that, the p-type semiconductor thin films are formed in the adjusting device, the i-type semiconductor thin films are formed by the reference device, and the n-type semiconductor thin films are formed by the other adjusting device.

The thin film forming system according to the present invention forms layered solar cells, made of p-type, i-type, and n-type semiconductor thin films, produced by the above thin film forming system; therefore, it is possible to form desirable layered solar cells.

Also, the fourth invention is a thin film forming system for forming silicon nitride gate insulating thin films and thin film transistors made of i-type and n-type semiconductor thin films. In the fourth invention, it is preferable that, the adjusting device, the reference device, and another adjusting device are disposed in that order in a direction of the substrates' transportation, the silicon nitride thin films are formed in the adjusting device, the i-type semiconductor thin films are formed in the adjusting device, and the n-type semiconductor thin films are formed by the other adjusting device.

The thin film forming system according to the present invention, forms thin film transistors, made of silicon nitride thin films, and i-type and n-type semiconductor thin films, produced by the above thin film forming system; therefore, it is possible to form desirable thin film transistors.

### BRIEF DESCRIPTION OF THE DRAWINGS

FIG. 1 is a diagram showing a thin film forming system according to a first embodiment of the present invention.
FIG. 2 is a diagram showing important sections in the thin film forming system according to the first embodiment of the present invention.
FIG. 3 is a diagram showing important sections in the thin film forming system according to a second embodiment of the present invention.
FIG. 4 is a diagram showing important sections in the thin film forming system according to a third embodiment of the present invention.
FIG. 5 is a diagram showing important sections in the thin film forming system according to a fourth embodiment of the present invention.
FIG. 6 is a diagram showing important sections in the thin film forming system according to a fifth embodiment of the present invention.
FIG. 7 is a diagram showing the thin film forming system according to a sixth embodiment of the present invention.
FIG. 8 is a diagram showing the thin film forming system according to a seventh embodiment of the present invention.
FIG. 9 is a diagram showing the thin film forming system according to an eighth embodiment of the present invention.
FIG. 10 is a diagram showing a conventional thin film forming system.
FIG. 11 is a diagram showing important sections in the conventional thin film forming system.
FIG. 12 is a diagram showing important sections in the conventional thin film forming system.

### BEST MODE FOR CARRYING OUT THE INVENTION

### (Embodiment 1)

Embodiments of the present invention are explained in detail with reference to drawings as follows.

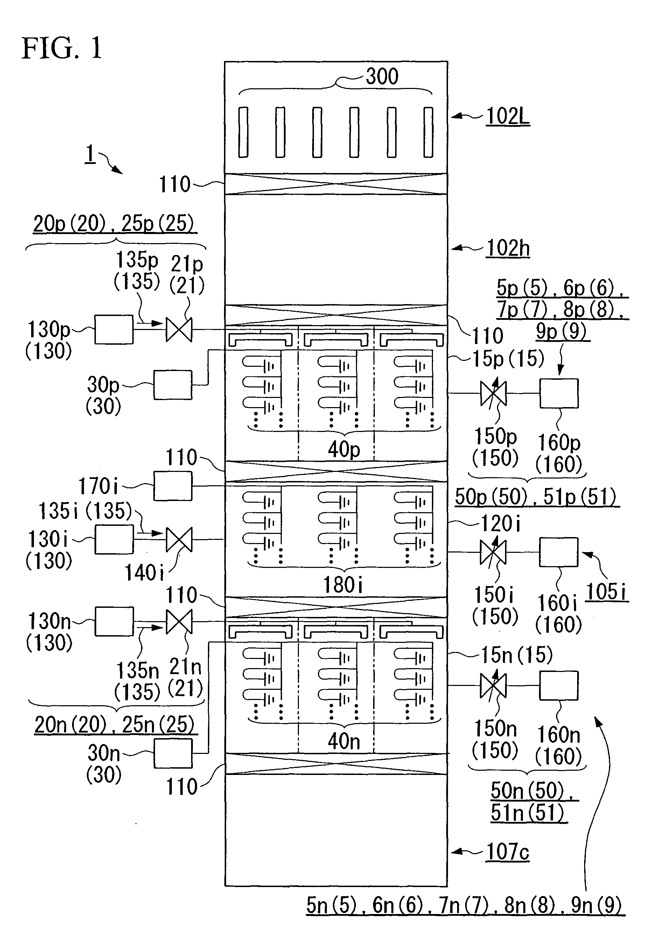

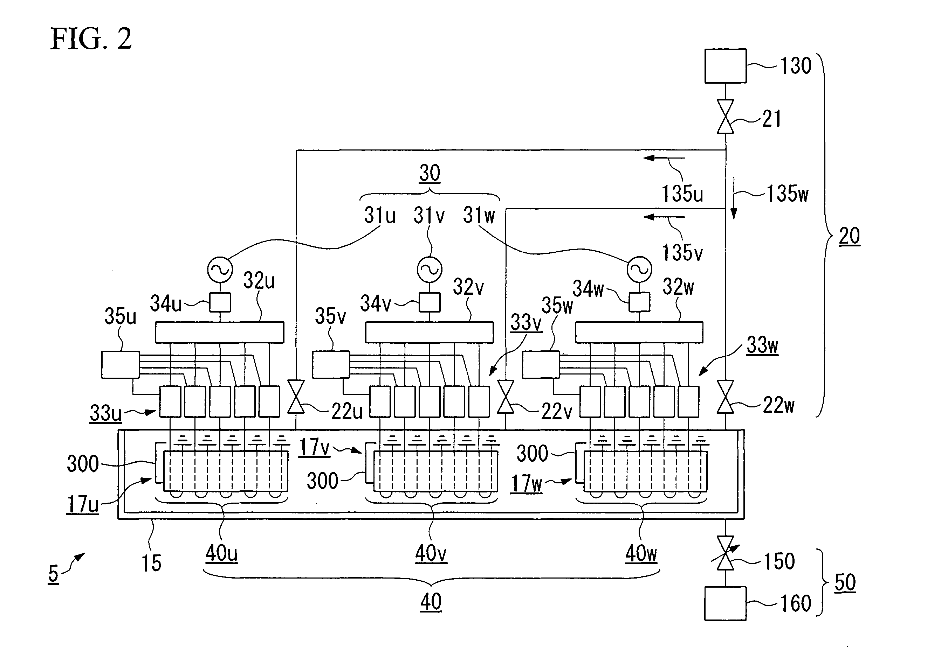

FIGS. 1 and 2 are diagrams showing a thin film forming system according to a first embodiment of the present invention. FIG. 1 is a diagram showing the thin film forming system for layering solar cell thin films. FIG. 2 is a diagram showing important sections of the thin film forming system shown in FIG. 1. In FIGS. 1 and 2, the same reference symbols are added to the same elements as those shown in FIGS. 10 to 12. Substrates 300, on which the thin films are formed in the present embodiment, are disposed perpendicularly to the plane of FIG. 1. Although, in FIG. 2, the substrates 300 and electrodes 40u, 40v, and 40w, should be disposed perpendicularly to the plane of FIG. 2 similar to in FIG. 1. However, for better understanding the operation of the thin film forming system, the substrates 300 and the plural sets of the electrodes are disposed horizontally to the plane of the drawing.

As shown in FIG. 1, the present embodiment is an inline-type thin film forming system 1, consisting of a load-lock device 102L for pressurizing an air around the substrates from vacuum state to an atmospheric pressure, a heating device 102h for heating the substrates, thin film forming devices 5p, 5i, and 5n, respectively forming p-type semiconductors, i-type semiconductors, and n-type semiconductors, a cooling device 107c for cooling the substrates, and gate valves 110 disposed between the devices.

The thin film forming devices 5 (5p, 5n) consist of one of chambers 15 (15, 15n), one of gas supply systems 20 (20p, 20n), one of power supply systems 30 (30p, 30n), one of pumping systems 50 (50p, 50n), one of substrate importing sections (importing sections) and one of substrate exporting sections (exporting sections), not shown in the drawings, respectively.

As shown in FIG. 2, each one of the chambers 15 (15p, 15n) consist of the thin film forming regions 17u, 17v, and 17w for forming the thin films on the substrates.

Each one of the gas supply systems 20 (20p, 20n) consists of gas boxes 130 (130p, 130n), the material gas supply valves 21 (21p, 21n) for supplying the material gases 135 (135p, 135n) to the chambers 15 (15p, 15n), and the material gas distributing supply valves 22 (22u, 22v, and 22w), such that the material gases are disposed on each one of the thin film forming regions 17u, 17v, and 17w.

The power supply systems 30 (30p, 30n) consist of the high frequency power supplies 31 (31u, 31v, and 31w), which are disposed in the thin film forming regions 17u, 17v, and 17w respectively, the dividers 32 (32u, 32v, and 32w), the circulators 33 (33u, 33v, and 33w), the selectors (switching devices) 34 (34u, 34v, and 34w), the dummy loads 35 (35u, 35v, and 35w), and the array-antennas (electrodes) 40 (40u, 40v, and 40w): thereby the electric power is supplied to the array-antennas 40u, 40v, and 40w respectively.

The pumping systems 50 (50p, 50n) consist of the pressure adjusting valves 150 (150p, 150n) and the vacuum pumps 160 (160p, 160n) such that the material gases supplied to each one of the thin film forming regions 17u, 17v, and 17w are pumped from the chambers 15 collectively.

Also, in the thin film forming device 1, operations of the thin film forming devices 5 (5p, 5n) for forming the p-type and the n-type semiconductor thin films are adjusted in accordance with a time for forming the i-type semiconductor thin films, having the largest thickness among the p-type, i-type, and the n-type semiconductor thin films forming the solar cell thin films, in the thin film forming device 105i.

More specifically, in the thin film forming device 5, operations in the selectors 34 (34u, 34v, and 34w) and in the gas supply systems 20 (20p, 20n) are adjusted; thus, the cost of the power supply systems 30 (30p, 30n) and for the material gases 135 (135p, 135in) are reduced, and the cost of the thin film forming system 1 is determined. Also, processing capacity in the thin film forming system 1 is determined based on the time for forming the thin films in the thin film forming devices 5 (5p, 5n) and in the thin film forming device 105i. Operation in the selectors 34 (34u, 34v, and 34w) or in the gas supply systems 20 (20p, 20n) is adjusted such that, the production cost per time and area, calculated based on the cost and the processing capacity of the thin film forming system 1, is moved toward a minimum.

Also, operation of the selectors 34 (34u, 34v, and 34w) or the gas supply systems 20 (20p, 20n) is adjusted. By doing this, it is possible to employ a power supply system having desirable electric capacity and vacuum pumps 160 (160p, 160n) having desirable pumping speed.

In the thin film forming system 1 having the above structure, the transporting devices (transporting system), not shown in the drawing, transport 6 (six) pieces of substrate 300 to the load-lock device 102L under an atmospheric condition, and after that, pressure around the substrates 300 is decompressed until all the air in the load-lock device 102L is evacuated.

After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h.

The substrates 300, disposed in the heating device 102h, are heated to a predetermined temperature by the heating device 102h.

Next, the gate valve 110, disposed between the heating device 102h and the thin film forming device 5p, opens, and the transporting devices, not shown in the drawing, transport the substrates 300 from the heating device 102h to the thin film forming device 5p; thus, the substrates 300 are disposed in each one of the thin film forming regions (17u, 17v, and 17w) in the chambers 15p.

An inside of the chamber 15p is maintained under a vacuum condition by the vacuum pump 160p so as to be ready to start forming the thin films on the substrates 300.

Next, a case, in which the thin films are formed in the thin film forming region 17u first in the chamber 15p (15) in the thin film forming device 5p (5), is explained.

The material gas 135u (135) is supplied to only the thin film forming region 17u from the gas box 130 by opening the material gas supply valve 21 and the material gas distributing supply valve 22u. A pressure in the chamber 15p (15) is adjusted by the pressure adjusting valve 150p. Also, the electric power is supplied from the high frequency power supply 31u to the array-antenna 40u via the selector 34u, the divider 32u, and the circulator 33u. The material gas 135u is plasmatized by the electric power supplied to the array-antenna 40u. The material gas in plasma state excited and decomposed to be a precursor. The precursors are deposited on the substrates 300 by surface reaction, the p-type semiconductor thin films are formed on the substrates 300.

Unnecessary gas generated in the above operation for forming the thin films is pumped by the vacuum pump 160 (160p).

Also, a portion of the electric power supplied to the array-antenna 40u is reflected as a reflection wave. The reflected wave is transmitted to the dummy load 35u, and thereby, exhausted as heat.

After desirable thin films are formed on the substrates 300, the material gas distributing supply valve 22u closes; thus, the operation for forming the thin films in the thin film forming region 17u is completed. A time for forming the above thin films is approximately 2 minutes.

Next, the thin films are formed in the thin film forming region 17v. The material gas 135v (135) is supplied to only the thin film forming region 17v by opening only the material gas distributing supply valve 22v. The electric power is supplied from the high frequency power supply 31v to the array-antenna 40v in the thin film forming region 17v, to which the material gas 135v is supplied. Accordingly, the p-type semiconductor thin films are formed on the substrates 300 similarly to when forming the thin films in the above explained thin film forming region 17u.

When the p-type semiconductor thin films are formed in the thin film forming region 17w, and the p-type semiconductor thin films are formed on all of the substrates 300 disposed in each one of the thin film forming regions 17u, 17v, and 17w, in the thin film forming device 5p (5), the operation for forming the thin films in the thin film forming device 5p (5) is completed.

A time for forming the above thin films in each one of the thin film forming regions 17u, 17v, and 17w in the thin film forming device 5p (5) is approximately 6 minutes.

In this case, the thin films are formed, in order, in each one of the thin film forming regions 17u, 17v, and 17w. Note that the present invention is not limited to the above order. That is, the order can be set desirably.

Next, the gate valve 110, disposed between the thin film forming devices 5p and 105i, opens, and the transporting devices, not shown in the drawing, transport the substrates 300 from the substrate exporting section in the thin film forming device 5p to the substrate importing section in the thin film forming device 105i; thus, the substrates 300 are disposed in each one of the thin film forming regions (121u, 121v, and 121w) in the chamber 120i.

In the thin film forming device 5p, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming regions 17v or 17w.

An inside of the chamber 120i is maintained under a vacuum condition by the vacuum pump 160i so as to be ready to start forming the thin films on the substrates 300.

Similarly to in the operations for forming the thin films in the above thin film forming device 5p, the material gas 135i is supplied from the gas box 130i to the chamber 120i. The electric power is supplied from the power supply system 170i (170) to the plural sets of the electrodes 181u, 181v, and 181w under the condition that a pressure inside the chamber 120i is adjusted by the pressure-adjusting valve 150i. By a chemical reaction for forming the thin films there, i-type semiconductor thin films are formed on the substrates 300.

The i-type semiconductor thin films are formed in the thin film forming regions 121u, 121v, and 121w simultaneously. A time for forming the i-type semiconductor thin films is approximately 20 minutes. The operation for forming the i-type semiconductor thin films is the throughput determining step in the thin film forming system for producing the solar cells.

In addition, the gate valve 110, disposed between the thin film forming devices 105i and 5n, opens, and the transporting devices, not shown in the drawing, transport the substrates 300 from the substrate exporting section in the thin film forming device 105i to the substrate importing section in the thin film forming device 5n; thus, the substrates 300 are disposed in each one of the thin film forming regions (17u, 17v, and 17w) in the chamber 15n.

In the thin film forming device 105p, the substrates 300, on which the thin films are formed in each one of the thin film forming regions, are not transported to another thin film forming region, in which different thin films are formed. For example, the substrates 300, on which the thin films are formed in the thin film forming region 121u, are not transported to either one of the thin film forming regions 121v or 121w.

An inside of the chamber 15n is maintained under a vacuum condition by the vacuum pump 160n so as to be ready to start forming the thin films on the substrates 300.

Next, a case, in which the thin films are formed in the thin film forming region 17u first in the chamber 15n (15) in the thin film forming device 5n (5), is explained.

The material gas 135u (135) is supplied to only the thin film forming region 17u from the gas box 130 by opening the material gas supply valve 21 and the material gas distributing supply valve 22u. A pressure in the chamber 15n (15) is adjusted by the pressure adjusting valve 150n. Also, the electric power is supplied from the high frequency power supply 31u to the array-antenna 40u via the selector 34u, the divider 32u, and the circulator 33u. The material gas 135u is plasmatized by the electric power supplied to the array-antenna 40u. The material gas in plasma state excited and decomposed to be a precursor. The precursors are deposited on the substrates 300 by surface reaction, the n-type semiconductor thin films are formed on the substrates 300.

Unnecessary gas generated in the above operation for forming the thin films is pumped by the vacuum pump (160) 160n.

Also, a portion of the electric power supplied to the array-antenna 40u is reflected as reflection wave. The reflection wave is transmitted to the dummy load 35u, and thereby, exhausted as heat.

After desirable thin films are formed on the substrates 300, the material gas distributing supply valve 22u closes; thus, the operation for forming the thin films in the thin film forming region 17u is completed. A time for forming the above thin films is approximately 2 minutes.

Next, the thin films are formed in the thin film forming region 17v. The material gas 135v (135) is supplied to only the thin film forming region 17v by opening only the material gas distributing supply valve 22v. The electric power is supplied from the high frequency power supply 31v to the array-antenna 40v in the thin film forming region 17v, to which the material gas 135v is supplied. Accordingly, the n-type semiconductor thin films are formed on the substrates 300 similarly to forming the thin films in the above explained thin film forming region 17u.

When the n-type semiconductor thin films are formed in the thin film forming region 17w, and the n-type semiconductor thin films are formed on all of the substrates 300 disposed in each one of the thin film forming regions 17u, 17v, and 17w, in the thin film forming device 5n (5), the operation for forming the thin films in the thin film forming device 5p (5) is completed.

A time for forming the above thin films in each one of the thin film forming regions 17u, 17v, and 17w in the thin film forming device 5n (5) is approximately 6 minutes.

In this case, the thin films are formed, in order, in each one of the thin film forming regions 17u, 17v, and 17w. Note that the present invention is not limited to the above order. That is, the order can be set desirably.

In the above operations for forming the thin films, any one of p-type, i-type, or n-type semiconductor thin film can be selectively disposed by changing the material gas 135 (135p, 135i, and 135n), which is supplied to each one of the thin film forming devices 5p, 105i, and 5n. By layering the semiconductor thin films in the above explained manner, p-i-n-junction semiconductor thin films are formed.

After the p-i-n junction semiconductor thin films are formed on the substrates 300, the gate valve 110, disposed between the thin film forming device 5n and the cooling device 107c, opens, and the transporting devices, not shown in the drawing, transport the substrates 300 from the thin film forming device 5n to the cooling device 107c; thus, the substrates 300 are disposed in the cooling device 107c.

In the thin film forming device 5n, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming region 17v or 17w.

The substrates 300 disposed in the cooling device 107c are cooled to a predetermined temperature, and after that, the transporting devices, not shown in the drawings, transport the substrates 300 to an unload-lock chamber, not shown in the drawing. Pressure in a vacuum space in the unload-lock chamber is pressurized to atmospheric pressure.

As explained above, in the thin film forming system 1, the material gases 135 (135u, 135v, and 135w) are supplied to only one of the thin film forming regions 17u, 17v, and 17w in the thin film forming device 5 (5p, 5n), and the thin films are formed step by step. Therefore, flow amount of the material gas necessary for forming the thin films in each one of the thin film forming regions may be less than the flow amount of the material gases 135 necessary for forming the thin films in all of the thin film forming regions 17u, 17v, and 17w simultaneously.

Therefore, in comparison to the case, in which the thin films are formed in all of the thin film forming regions 17u, 17v, and 17w simultaneously, the pumping speed necessary to the vacuum pumps 160 (160p, 160n) may be smaller. Therefore, size of the vacuum pumps can be reduced, and the cost of the thin film forming device can be reduced. That is, the cost of an entire thin film forming system can be reduced.

Also, the operation of the thin film forming device 5 (5p, 5n) is adjusted in accordance with the time for forming the thin films in the thin film forming device 105i. The material gases 135 (135u, 135v, and 135w) are supplied to only one of the thin film forming regions. By doing this, the thin films are formed step by step. Therefore, the thin films can be formed without deteriorating a total efficiency of the thin film forming system 1.

In addition, with respect to time and conditions for forming various and desirable solar cell thin films, power supply systems, having desirable power capacity, and the pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 5p, 5n, and 105i. After the formation of the thin films thereon, the substrates 300 are transported by a substrate exporting section different from the substrate importing section. Therefore, the transportation of the substrates is not reciprocal; thus, the substrate having the thin films can be transported efficiently.

In the present embodiment, various operations are conducted while 6 (six) pieces of the substrate are transported into the thin film forming system 1. However, the quantity of the substrates is not limited to six pieces. That is, the quantity of the substrates can be set desirably.

### (Embodiment 2)

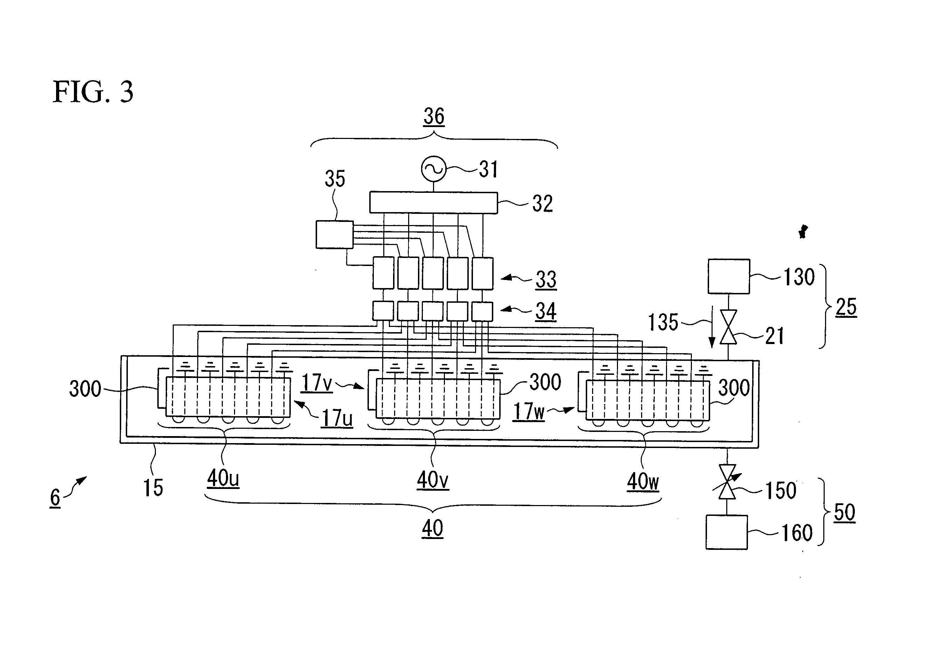

FIG. 3 is a diagram showing an important portion of the thin film forming system according to a second embodiment of the present invention. That is, the important portion indicates the thin film forming device (adjusting device) 6 (6p, 6n), which is disposed in the thin film forming system 1, in place of the thin film forming devices 5p, 5n shown in FIG. 1. The rest of the elements consisting of the thin film forming system according to the present embodiment are the same as those described with respect to the embodiment 1. The substrates 300 are disposed perpendicularly to the plane of FIG. 3 similarly to in FIG. 1. However, in FIG. 3, for better understanding the operation of the thin film forming system, the substrates are disposed horizontally to the plane of the drawing.

As shown in FIG. 3, the thin film forming device 6 (6p, 6n) consists of the same elements as those of the thin film forming device shown in FIG. 2 except for the gas supply systems 25 (25p, 25n) and power supply systems 36 (36p, 36n). The same reference symbols are added to the same elements.

Each one of the gas supply systems 25 (20p, 20n) consists of gas boxes 130 (130p, 130n) for supplying the material gases 135 (135p, 135n), and the material gas supply valves 21 (21p, 21n) for supplying the material gases 135 (135p, 135n) to the chambers 15 (15p, 15n), such that the material gases 135 (135p, 135n) are supplied to the chambers 15 (15p, 15n) collectively.

With respect to the chamber 15 (15p, 15n), the power supply system 36 (36p, 36n) consists of a high frequency power supply 31, a divider 32, circulators 33, selectors 34, and a dummy load 35. Array-antennas 40 (40u, 40v, and 40w) are disposed corresponding to each one of thin film forming regions 17u, 17v, and 17w. The selectors 34 connect one of the circulators 33 to one of the array-antennas 40 (40u, 40v, and 40w) selectively; thus, the electric power is supplied from the high frequency power supply 31 to the array-antenna 40.

Also, in the thin film forming system according to the present embodiment, similarly to in the embodiment 1, operations of the thin film forming devices 6 (6p, 6n) for forming the p-type and the n-type semiconductor thin films are adjusted in accordance with a time for forming the i-type semiconductor thin films, having the largest thickness among the p-type, i-type, and the n-type semiconductor thin films forming the solar cell thin films, in the thin film forming device 105i. The details thereof are the same as those explained for embodiment 1.

In the thin film forming system having the above structure, the transporting devices (transporting system), not shown in the drawing, transport the substrates 300 to the load-lock chamber 102L under atmospheric condition, and after that, pressure around the substrates 300 is decompressed until all the air in the load-lock chamber 102L is evacuated.

After that, the gate valve 110, disposed between the load-lock chamber 102L and the heating chamber 102h, opens, and the transporting devices, not shown in the drawing, transport the substrates 300 from the load-lock chamber 102L to the heating chamber 102h; thus, the substrates 300 are disposed in the heating chamber 102h.

The substrates 300, disposed in the heating chamber 102h, are heated to a predetermined temperature by the heating chamber 102h.

Next, the gate valve 110, disposed between the heating device 102h and the thin film forming device 6p, opens, and the transporting devices, not shown in the drawing, transport the substrates 300 from the heating device 102h to the thin film forming device 6p; thus, the substrates 300 are disposed in each one of the thin film forming regions (17u, 17v, and 17w) in the chambers 15p.

An inside of the chamber 15p is maintained under a vacuum condition by the vacuum pump 160p so as to be ready to start forming the thin films on the substrates 300.

Next, a case, in which the thin films are formed in the thin film forming region 17u first in the chamber 15p (15) in the thin film forming device 6p (6), is explained.

First, the selectors 34 select the array-antenna 40u from the array-antennas 40u, 40v, and 40w, and connect the circulators 33 and the array-antenna 40u. Accordingly, the material gases 135 are supplied from the gas box 130 to the chamber 15p (15) by opening the material gas supply valve 21. A pressure inside of the chamber 15p (15) is adjusted by the pressure adjusting valve 150. The electric power is supplied from the high frequency power supply 31 to the array-antenna 40u via the divider 32, the circulators 33, and the selectors 34. The material gas 135 is plasmatized by the electric power supplied to the array-antenna 40u. The material gas in plasma state excited and decomposed to be a precursor. The precursors are deposited on the substrates 300 by surface reaction in the tin film forming region 17u; thus, the p-type semiconductor thin films are formed on the substrates 300.

Unnecessary gas generated in the above operation for forming the thin films is pumped by the vacuum pump (160) 160p.

Also, a portion of the electric power supplied to the array-antenna 40u is reflected as reflection wave. The reflection wave is transmitted to the dummy load 35u, and thereby, exhausted as heat.

After desirable thin films are formed on the substrates 300, the material gas supply valve 21 closes; thus, the operation for forming the thin films in the thin film forming region 17u is completed. A time for forming the above thin films is approximately 2 minutes.

Next, the thin films are formed in the thin film forming region 17v. In this case, the selectors 34 select the array-antenna 40v, and connect the circulators 33 and the array-antenna 40v. Accordingly, the material gases 135 are supplied from the gas box 130 to the chamber 15p (15) by opening the material gas supply valve 21. By doing this, the p-type semiconductor thin films are formed on the substrates 300 similarly to forming the thin films in the above explained thin film forming region 17u.

When the p-type semiconductor thin films are formed in the thin film forming region 17w, and the p-type semiconductor thin films are formed on all of the substrates 300 disposed in each one of the thin film forming regions 17u, 17v, and 17w, in the thin film forming device 6p (6), the operation for forming the thin films in the thin film forming device 6p (6) is completed.

A total time for forming the above thin films in each one of the thin film forming regions 17u, 17v, and 17w in the thin film forming device 6p (6) is approximately 6 minutes.

In this case, the thin films are formed, in order, in each one of the thin film forming regions 17u, 17v, and 17w. Note that the present invention is not limited to the above order. That is, the order can be set desirably.

Next, the gate valve 110, disposed between the thin film forming devices 6p and 105i, opens, and the transporting devices, not shown in the drawing, transport the substrates 300 from the substrate exporting section in the thin film forming device 6p to the substrate importing section in the thin film forming device 105i; thus, the substrates 300 are disposed in each one of the thin film forming regions (121u, 121v, and 121w) in the chamber 120i.

In the thin film forming device 6p, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming regions 17v or 17w.

An inside of the chamber 120i is maintained under a vacuum condition by the vacuum pump 160i so as to be ready to start forming the thin films on the substrates 300.

Similarly to in the operations for forming the thin films in the above thin film forming device 6p, the material gas 135i is supplied from the gas box 130i to the chamber 120i. The electric power is supplied from the power supply system 170i (170) to the plural sets of the electrodes 181u, 181v, and 181w under the condition that a pressure inside the chamber 120i is adjusted by the pressure-adjusting valve 150i. By a chemical reaction for forming the thin films there, i-type semiconductor thin films are formed on the substrates 300.

The i-type semiconductor thin films are formed in the thin film forming regions 121 u, 121 v, and 121 w simultaneously. A time for forming the i-type semiconductor thin films is approximately 20 minutes. The operation for forming the i-type semiconductor thin films is the throughput determining step in the thin film forming system for producing the solar cells.

In addition, the gate valve 110, disposed between the thin film forming devices 105i and 6n, opens, and the transporting devices, not shown in the drawing, transport the substrates 300 from the substrate exporting section in the thin film forming device 105i to the substrate importing section in the thin film forming device 6n; thus, the substrates 300 are disposed in each one of the thin film forming regions (17u, 17v, and 17w) in the chamber 15n.

In the thin film forming device 105p, the substrates 300, on which the thin films are formed in each one of the thin film forming regions, are not transported to another thin film forming region, in which different thin films are formed. For example, the substrates 300, on which the thin films are formed in the thin film forming region 121u, are not transported to either one of the thin film forming regions 121v or 121 w.

An inside of the chamber 15n is maintained under a vacuum condition by the vacuum pump 160n so as to be ready to start forming the thin films on the substrates 300.

Next, a case, in which the thin films are formed in the thin film forming region 17u first in the chamber 15n (15) in the thin film forming device 6n (6), is explained.

First, the selectors 34 select the array-antenna 40u from the array-antennas 40u, 40v, and 40w, and connect the circulators 33 and the array-antenna 40u. Accordingly, the material gases 135 are supplied from the gas box 130 to the chamber 15p (15) by opening the material gas supply valve 21. A pressure inside of the chamber 15p (15) is adjusted by the pressure adjusting valve 150. The electric power is supplied from the high frequency power supply 31 to the array-antenna 40u via the divider 32, the circulators 33, and the selectors 34. The material gas 135 is plasmatized by the electric power supplied to the array-antenna 40u. The material gas in plasma state excited and decomposed to be a precursor. The precursors are deposited on the substrates 300 by surface reaction in the thin film forming region 17u; thus, the n-type semiconductor thin films are formed on the substrates 300.

Unnecessary gas generated in the above operation for forming the thin films is pumped by the vacuum pump (160) 160n.

Also, a portion of the electric power supplied to the array-antenna 40u is reflected as a reflection wave. The reflection wave is transmitted to the dummy load 35u, and thereby, exhausted as heat.

After desirable thin films are formed on the substrates 300, the material gas supply valve 21 closes; thus, the operation for forming the thin films in the thin film forming region 17u is completed. A time for forming the above thin films is approximately 2 minutes.

Next, the thin films are formed in the thin film forming region 17v. In this case, the selectors 34 select the array-antenna 40v, and connect the circulators 33 and the array-antenna 40v. Accordingly, the material gases 135 are supplied from the gas box 130 to the chamber 15n (15) by opening the material gas supply valve 21. By doing this, the n-type semiconductor thin films are formed on the substrates 300 similarly to when forming the thin films in the above explained thin film forming region 17u.

When the n-type semiconductor thin films are formed in the thin film forming region 17w, and the n-type semiconductor thin films are formed on all of the substrates 300 disposed in each one of the thin film forming regions 17u, 17v, and 17w, in the thin film forming device 6n (6), the operation for forming the thin films in the thin film forming device 6n (6) is completed.

A total time for forming the above thin films in each one of the thin film forming regions 17u, 17v, and 17w in the thin film forming device 6n (6) is approximately 6 minutes.

In this case, the thin films are formed, in order, in each one of the thin film forming regions 17u, 17v, and 17w. Note that the present invention is not limited to the above order. That is, the order can be set desirably.

In the above operations for forming the thin films, any one of p-type, i-type, or n-type semiconductor thin film can be selectively disposed by changing the material gas 135 (135p, 135i, and 135n), which is supplied to each one of the thin film forming devices 6p, 105i, and 6n. By layering the semiconductor thin films in the above explained manner, pin-junction semiconductor thin films are formed.

After the p-i-n-junction semiconductor thin films are formed on the substrates 300, the gate valve 110, disposed between the thin film forming device 6n and the cooling device 107c, opens, and the transporting devices, not shown in the drawing, transport the substrates 300 from the thin film forming device 6n to the cooling device 107c; thus, the substrates 300 are disposed in the cooling device 107c.

In the thin film forming device 6n, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming regions 17v or 17w.

The substrates 300 disposed in the cooling device 107c are cooled to a predetermined temperature, and after that, the transporting devices, not shown in the drawings, transport the substrates 300 to an unload-lock chamber, not shown in the drawing. Pressure in a vacuum space in the unload-lock chamber is pressurized to atmospheric pressure..

Also, in this thin film forming system, the thin films are transported in order to the load-lock device 102L, the heating device 102h, the thin film forming devices 6p, 105i, and 6n, and the cooling device 107c at the same time as each other.

As explained above, in this thin film forming system, the thin films are formed in at least one of the thin film forming regions 17u, 17v, and 17w, which belongs to the array-antenna selected by the selectors 34, and each of the selected thin film forming regions are selected further. Therefore, a high frequency power supply for supplying a high power electric power to all of the thin film forming devices is unnecessary. Also, the power supply system can be simplified, and the cost of the thin film forming devices can be reduced. That is, the cost of the entire thin film forming system can be reduced.

Also, the operation of the thin film forming device 6 (6p, 6n) is adjusted in accordance with the time for forming the thin films in the thin film forming device 105i. The thin films are formed in at least one of the thin film forming regions, which belongs to the array-antenna selected by the selectors 34, and each of the selected thin film forming regions are selected further. Therefore, the thin films can be formed without deteriorating a total efficiency of the thin film forming system.

In addition, with respect to time and conditions for forming various and desirable solar cell thin films, power supply systems, having desirable power capacity, and pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 6p, 6n, and 105i. After the formation of the thin films thereon, the substrates 300 are transported by the substrate exporting section different from the substrate importing section. Therefore, the transportation of the substrates is not reciprocal; thus, the substrate having the thin films can be transported efficiently.

In the present embodiment, the thin film forming device 6 (6p, 6n) has three sets of the thin film forming regions. However, the present invention is not limited to three sets of the thin film forming regions, as long as the thin film forming device has at least two sets of the thin film forming regions.

Also, in the present embodiment, each one of the array-antennas 40 (40u, 40v, and 40w) is disposed in one of the thin film forming regions 17u, 17v, and 17w. However, parallel plate electrodes having an anode and a cathode may be disposed in place of the array-antennas.

Also, in the present embodiment, the selectors 34 select one of the array-antennas. However, the quantity of the selected array-antennas is not limited to one piece. That is, when the substrates are formed, the selectors 34 may select two or more array-antennas so that the thin film as long as the high frequency power supply 31 has power capacity for supplying sufficient electric power to the at least two array-antennas.

### (Embodiment 3)

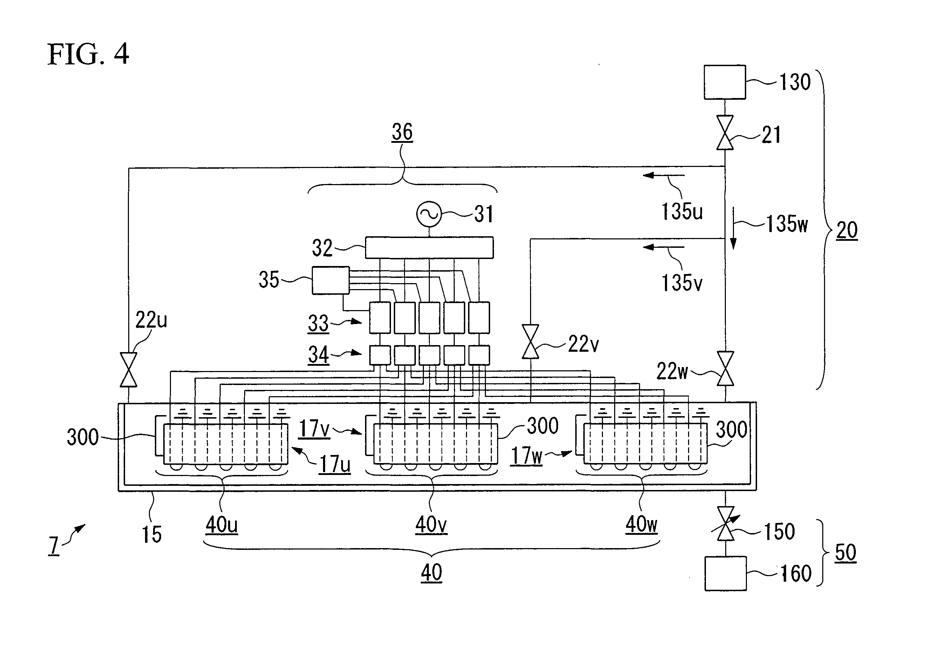

FIG. 4 is a diagram showing an important portion of the thin film forming system according to a third embodiment of the present invention. That is, the important portion indicates the thin film forming device (adjusting device) 7 (7p, 7n), which is disposed in the thin film forming system 1, in place of the thin film forming devices 5p, 5n, shown in FIG. 1. The rest of the elements consisting of the thin film forming system 1 are the same as those described with respect to embodiment 1. The substrates 300 are disposed perpendicularly to the plane of FIG. 4 similarly to in FIG. 1. However, in FIG. 3, for better understanding the operation of the thin film forming system, the substrates are disposed horizontally to the plane of the drawing.

Each one of the thin film forming devices 7 (7p, 7n) consists of one of chambers 15 (15, 15n), one of gas supply systems 20 (20p, 20n), one of power supply systems 36 (36p, 36n), one of pumping systems 50 (50p, 50n), one of substrate importing sections (importing sections) and one of substrate exporting sections (exporting sections), not shown in the drawings, respectively. These are the same as explained with reference to FIGS. 2 and 3.

Also, in the thin film forming system according to the present embodiment, similarly to in embodiment 1, operations of the thin film forming devices 7 (7p, 7n) for forming the p-type and the n-type semiconductor thin films are adjusted in accordance with a time for forming the i-type semiconductor thin films, having the largest thickness among the p-type, i-type, and the n-type semiconductor thin films forming the solar cell thin films, in the thin film forming device 105i. The details thereof are the same as those explained for embodiment 1.

In the thin film forming system having the above structure, the transporting devices (transporting system), not shown in the drawing, transport the substrates 300 to the load-lock chamber 102L under an atmospheric condition, and after that, an pressure around the substrates 300 is decompressed until all the air in the load-lock chamber 102L is evacuated.

After that, the gate valve 110, disposed between the load-lock chamber 102L and the heating chamber 102h, opens, and the transporting devices, not shown in the drawing, transport the substrates 300 from the load-lock chamber 102L to the heating chamber 102h; thus, the substrates 300 are disposed in the heating chamber 102h.

The substrates 300, disposed in the heating chamber 102h, are heated to a predetermined temperature by the heating chamber 102h.

Next, the gate valve 110, disposed between the heating device 102h and the thin film forming device 7p, opens, and the transporting devices, not shown in the drawing, transport the substrates 300 from the heating device 102h to the thin film forming device 7p; thus, the substrates 300 are disposed in each one of the thin film forming regions (17u, 17v, and 17w) in the chambers 15p.

An inside of the chamber 15p is maintained under a vacuum condition by the vacuum pump 160p so as to be ready to start forming the thin films on the substrates 300.

Next, a case, in which the thin films are formed in the thin film forming region 17u first in the chamber 15p (15) in the thin film forming device 7p (7), is explained.

First, the selectors 34 select the array-antenna 40u from the array-antennas 40u, 40v, and 40w, and connect the circulators 33 and the array-antenna 40u. The material gas 135u (135) is supplied to only the thin film forming region 17u from the gas box 130 by opening the material gas supply valve 21 and the material gas distributing supply valve 22u. A pressure in the chamber 15p (15) is adjusted by the pressure adjusting valve 150p. The electric power is supplied from the high frequency power supply 31 to the array-antenna 40u via the divider 32, the circulators 33, and the selectors 34. The material gas 135 is plasmatized by the electric power supplied to the array-antenna 40u. The material gas in plasma state excited and decomposed to be a precursor. The precursors are deposited on the substrates 300 by surface reaction in the thin film forming region 17u; thus, the p-type semiconductor thin films are formed on the substrates 300.

Unnecessary gas generated in the above operation for forming the thin films is pumped by the vacuum pump (160) 160p.

Also, a portion of the electric power supplied to the array-antenna 40u is reflected as a reflection wave. The reflection wave is transmitted to the dummy load 35u, and thereby, exhausted as heat.

After desirable thin films are formed on the substrates 300, the material gas supply valve 21 closes; thus, the operation for forming the thin films in the thin film forming region 17u is completed. A time for forming the above thin films is approximately 2 minutes.

Next, the thin films are formed in the thin film forming region 17v. In this case, the selectors 34 select the array-antenna 40v, and connect the circulators 33 and the array-antenna 40v. The material gas 135v (135) is supplied to only the thin film forming region 17v by opening only the material gas distributing supply valve 22v. The electric power is supplied from the high frequency power supply 31v to the array-antenna 40v in the thin film forming region 17v, to which the material gas 135v is supplied. Accordingly, the p-type semiconductor thin films are formed on the substrates 300 similarly to when forming the thin films in the above explained thin film forming region 17u.

When the p-type semiconductor thin films are formed in the thin film forming region 17w, and the p-type semiconductor thin films are formed on all of the substrates 300 disposed in each one of the thin film forming regions 17u, 17v, and 17w, in the thin film forming device 6p (7), the operation for forming the thin films in the thin film forming device 7p (7) is completed.

A total time for forming the above thin films in each one of the thin film forming regions 17u, 17v, and 17w in the thin film forming device 7p (7) is approximately 6 minutes.

In this case, the thin films are formed, in order, in each one of the thin film forming regions 17u, 17v, and 17w. Note that the present invention is not limited to the above order. That is, the order can be set desirably.

Next, the gate valve 110, disposed between the thin film forming devices 7p and 105i, opens, and the transporting devices, not shown in the drawing, transport the substrates 300 from the substrate exporting section in the thin film forming device 7p to the substrate importing section in the thin film forming device 105i; thus, the substrates 300 are disposed in each one of the thin film forming regions (121u, 121v, and 121w) in the chamber 120i.

In the thin film forming device 7p, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming region 17v or 17w.

An inside of the chamber 120i is maintained under a vacuum condition by the vacuum pump 160i so as to be ready to start forming the thin films on the substrates 300.

Similarly to in the operations for forming the thin films in the above thin film forming device 7p, the material gas 135i is supplied from the gas box 130i to the chamber 120i. The electric power is supplied from the power supply system 170i (170) to the plural sets of the electrodes 181u, 181v, and 181w under the condition that a pressure inside the chamber 120i is adjusted by the pressure-adjusting valve 150i. By a chemical reaction for forming the thin films there, i-type semiconductor thin films are formed on the substrates 300.

The i-type semiconductor thin films are formed in the thin film forming regions 121u, 121v, and 121w simultaneously. A time for forming the i-type semiconductor thin films is approximately 20 minutes. The operation for forming the i-type semiconductor thin films is the throughput determining step in the thin film forming system for producing the solar cells.

The gate valve 110, disposed between the thin film forming devices 105i and 7n, opens, and the transporting devices, not shown in the drawing, transport the substrates 300 from the substrate exporting section in the thin film forming device 105i to the substrate importing section in the thin film forming device 7n; thus, the substrates 300 are disposed in each one of the thin film forming regions (17u, 17v, and 17w) in the chamber 15n.

In the thin film forming device 105p, the substrates 300, on which the thin films are formed in each one of the thin film forming regions, are not transported to another thin film forming region, in which different thin films are formed. For example, the substrates 300, on which the thin films are formed in the thin film forming region 121u, are not transported to either one of the thin film forming regions 121v or 121w.

An inside of the chamber 15n is maintained under a vacuum condition by the vacuum pump 160n so as to be ready to start forming the thin films on the substrates 300.

Next, a case, in which the thin films are formed in the thin film forming region 17u first in the chamber 15n (15) in the thin film forming device 7n (7), is explained.

First, the selectors 34 select the array-antenna 40u from the array-antennas 40u, 40v, and 40w, and connect the circulators 33 and the array-antenna 40u. The material gas 135u (135) is supplied to only the thin film forming region 17u from the gas box 130 by opening the material gas supply valve 21 and the material gas distributing supply valve 22u. A pressure in the chamber 15n (15) is adjusted by the pressure adjusting valve 150n. The electric power is supplied from the high frequency power supply 31 to the array-antenna 40u via the divider 32, the circulators 33, and the selectors 34. The material gas 135 is plasmatized by the electric power supplied to the array-antenna 40u. The material gas in plasma state excited and decomposed to be a precursor. The precursors are deposited on the substrates 300 by surface reaction; thus, the n-type semiconductor thin films are formed on the substrates 300.

Unnecessary gas generated in the above operation for forming the thin films is pumped by the vacuum pump (160) 160n.

Also, a portion of the electric power supplied to the array-antenna 40u is reflected as a reflection wave. The reflection wave is transmitted to the dummy load 35u, and thereby, exhausted as heat.

After desirable thin films are formed on the substrates 300, the material gas supply valve 21 closes; thus, the operation for forming the thin films in the thin film forming region 17u is completed. A time for forming the above thin films is approximately 2 minutes.

Next, the thin films are formed in the thin film forming region 17v.In this case, the selectors 34 select the array-antenna 40v, and connect the circulators 33 and the array-antenna 40v. The material gas 135v (135) is supplied to only the thin film forming region 17v by opening only the material gas distributing supply valve 22v. The electric power is supplied from the high frequency power supply 31v to the array-antenna 40v in the thin film forming region 17v, to which the material gas 135v is supplied. Accordingly, the n-type semiconductor thin films are formed on the substrates 300 similarly to when forming the thin films in the above explained thin film forming region 17u.

When the n-type semiconductor thin films are formed in the thin film forming region 17w, and the n-type semiconductor thin films are formed on all of the substrates 300 disposed in each one of the thin film forming regions 17u, 17v, and 17w, in the thin film forming device 7n (7), the operation for forming the thin films in the thin film forming device 6n (7) is completed.

A time for forming the above thin films in each one of the thin film forming regions 17u, 17v, and 17w in the thin film forming device 7n (7) is approximately 6 minutes.

In this case, the thin films are formed, in order, in each one of the thin film forming regions 17u, 17v, and 17w. Note that the present invention is not limited to the above order. That is, the order can be set desirably.

In the above operations for forming the thin films, any one of p-type, i-type, or n-type semiconductor thin film can be selectively disposed by changing the material gas 135 (135p, 135i, and 135n), which are supplied to each one of the thin film forming devices 7p, 105i, and 7n. By layering the semiconductor thin films in the above explained manner, pin-junction semiconductor thin films are formed.

After the p-i-n-junction semiconductor thin films are formed on the substrates 300, the gate valve 110, disposed between the thin film forming device 7n and the cooling device 107c, opens, and the transporting devices, not shown in the drawing, transport the substrates 300 from the thin film forming device 7n to the cooling device 107c; thus, the substrates 300 are disposed in the cooling device 107c.

In the thin film forming device 7n, the substrates 300, on which the thin films are formed in each one of the thin film forming regions, are not transported to another thin film forming region, in which different thin films are formed. For example, the substrates 300, on which the thin films are formed in the thin film forming region 17u, are not transported to either one of the thin film forming region 17v or 17w.

The substrates 300 disposed in the cooling device 107c are cooled to a predetermined temperature, and after that, the transporting devices, not shown in the drawings, transport the substrates 300 to an unload-lock chamber, not shown in the drawing. Pressure in a vacuum space in the unload-lock chamber is pressurized to atmospheric pressure.

Also, in this thin film forming system, the thin films are transported in a direction, in order to the load-lock device 102L, the heating device 102h, the thin film forming devices 7p, 105i, and 7n, and the cooling device 107c at the same time as each other.

As explained above, in the thin film forming system, the material gases 135 (135u, 135v, and 135w) are supplied to only one of the thin film forming regions 17u, 17v, and 17w, to which the selected array-antenna belongs, in the thin film forming device 7 (7p, 7n), and the thin films are formed step by step while the thin film forming regions are selected further. Therefore, flow amount of the material gas necessary for forming the thin films in each one of the thin film forming regions may be less than the flow amount of the material gases 135 necessary for forming the thin films in all of the thin film forming regions 17u, 17v, and 17w simultaneously. Therefore, with respect to the case, in which the thin films are formed in all of the thin film forming regions 17u, 17v, and 17w simultaneously, the pumping speed necessary for the vacuum pumps 160 (160p, 160n) may be smaller. Therefore, the size of the vacuum pumps can be reduced. Also, a high frequency power supply for supplying electric power to all of the thin film forming regions 17u, 17v, and 17w simultaneously is unnecessary. Also, the power supply system can be simplified. The cost of the thin film forming device can be reduced; that is, the cost of the entire thin film forming system can be reduced.

Also, the operation of the thin film forming device 7 (7p, 7n) is adjusted in accordance with the time for forming the thin films in the thin film forming device 105i. The thin films are formed in at least one of the thin film forming regions, which belongs to the array-antenna selected by the selectors 34, and each of the selected thin film forming regions are selected further. Therefore, the thin films can be formed without reducing a total efficiency of the thin film forming system.

In addition, with respect to time and conditions for forming various and desirable solar cell thin films, power supply systems, having desirable power capacity, and the pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 7p, 7n, and 105i. After the formation of the thin films thereon, the substrates 300 are transported by the substrate exporting section different from the substrate importing section. Therefore, the transportation of the substrates is not reciprocal; thus, the substrate having the thin films can be transported efficiently.

### (Embodiment 4)

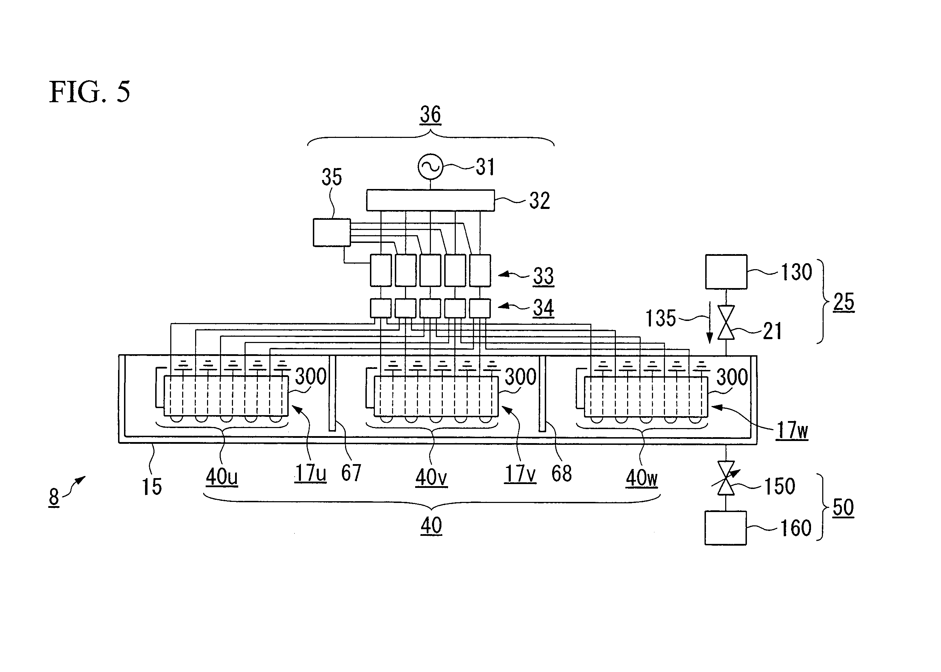

FIG. 5 is a diagram showing an important portion of the thin film forming system according to a fourth embodiment of the present invention. That is, the important portion indicates the thin film forming device (adjusting device) 8 (8p, 8n), which is disposed in the thin film forming system 1, in place of the thin film forming devices 5p, 5n, shown in FIG. 1. The rest of the elements consisting of the thin film forming system 1 are the same as those described with respect to embodiment 1. In the present embodiment, structures the same as those shown in FIGS. 1 to 4 are not explained; therefore, only different structures are explained. Also, the substrates 300 are disposed perpendicularly to the plane of FIG. 5 as similarly to in FIG. 1. However, in FIG. 5, for better understanding the operation of the thin film forming system, the substrates are disposed horizontally to the plane of the drawing.

As shown in FIG. 5, barrier plates 67 and 68 are disposed on borders among the thin film forming regions 17u, 17v, and 17w in the thin film forming device 8 (8p, 8n). The rest of the structures in FIG. 5 are the same as the thin film forming device 6 shown in FIG. 3. In the drawings, the same reference symbols are added to the same structures.

With respect to the thin film forming system having the above structures, a case, in which the thin films are formed in the thin film forming region 17u first in the chamber 15p (15) in the thin film forming device 8p (8), is explained.

First, the selectors 34 select the array-antenna 40u from the array-antennas 40u, 40v, and 40w, and connect the circulators 33 and the array-antenna 40u. Accordingly, the material gases 135 are supplied from the gas box 130 to the chamber 15p (15) by opening the material gas supply valve 21. A pressure inside of the chamber 15p is adjusted by the pressure adjusting valve 150. The electric power is supplied from the high frequency power supply 31 to the array-antenna 40u via the divider 32, the circulators 33, and the selectors 34. The material gas 135 is plasmatized by the electric power supplied to the array-antenna 40u. The material gas in plasma state excited and decomposed to be a precursor. The precursors are deposited on the substrates 300 by surface reaction in the thin film forming region 17u; thus, the p-type semiconductor thin films are formed on the substrates 300.

The barrier plate 67 prevents the material gases 135, excited and decomposed in the thin film forming region 17u, from diffusing to the thin film forming regions 17v and 17w. Therefore, the excited and decomposed material gases 135 do not enter the thin film forming regions 17v and 17w, and thereby, the thin films are not formed on the substrates 300 disposed in each one of the thin film forming regions 17v and 17w. That is, by a chemical reaction of the material gases 135, excited and decomposed in the thin film forming region 17u, for forming the thin films thereon, the thin films are formed on the substrates 300.

Unnecessary gas generated in the above operation for forming the thin films is pumped by the vacuum pump (160) 160p.

Also, a portion of the electric power supplied to the array-antenna 40u is reflected as a reflection wave. The reflection wave is transmitted to the dummy load 35u, and thereby, exhausted as heat.

Next, the thin films are formed in the thin film forming region 17v. In this case, the selectors 34 select the array-antenna 40v, and connect the circulators 33 and the array-antenna 40v. Accordingly, the material gases 135 are supplied from the gas box 130 to the chamber 15p (15) by opening the material gas supply valve 21. By doing this, the p-type semiconductor thin films are formed on the substrates 300 similarly to when forming the thin films in the above explained thin film forming region 17u.

The barrier plates 67 and 68 prevent the material gases 135, excited and decomposed in the thin film forming region 17u, from diffusing to the thin film forming regions 17u and 17w. Therefore, the excited and decomposed material gases 135 do not enter the thin film forming regions 17u and 17w, and thereby, the thin films are not formed on the substrates 300 disposed in each one of the thin film forming regions 17u and 17w. That is, by a chemical reaction of the material gases 135, excited and decomposed in the thin film forming region 17v, for forming the thin films thereon, the thin films are formed on the substrates 300.

While restricting the dispersion of the material gases 135 from the thin film forming regions 17u and 17w by the barrier plate 68, the p-type semiconductor thin films are formed in the thin film forming region 17w, and the p-type semiconductor thin films are formed on all of the substrates 300 disposed in each one of the thin film forming regions 17u, 17v, and 17w, in the thin film forming device 8p (8). The operation for forming the thin films in the thin film forming device 8p (8) is then completed.

In this case, the thin films are formed, in order, in each one of the thin film forming regions 17u, 17v, and 17w. Note that the present invention is not limited to the above order. That is, the order can be set desirably.

Also, the barrier plates 68 and 67 are disposed in the thin film forming device 8n similar to the above thin film forming device 8p. While restricting the dispersion of the material gases 135 by the barrier plates 67 and 68, the n-type semiconductor thin films are formed in all of the thin film forming regions 17u, 17v, and 17w, in the thin film forming device 8n (8). By doing this, the operation for forming the thin films in the thin film forming device 8n (8) is completed.

As explained above, the barrier plates 67 and 68 are disposed in the thin film forming devices 8(8p, 8n); therefore, the material gas, excited and decomposed in one of the thin film forming regions, is prevented from diffusing to another one of the thin film forming regions. Therefore, the formation of the thin films on the substrates 300, disposed in another one of the thin film forming regions, can be prevented.

In the present embodiment, each one of the barrier plates 67 and 68 is disposed on one of the borders, between the thin film forming regions 17u and 17v, and between 17v and 17w. However, the barrier plates may be disposed so as to contact the substrates.

Although one barrier plate is disposed on each one of the borders, a plurality of the barrier plates may be disposed on each one of the borders.

### (Embodiment 5)

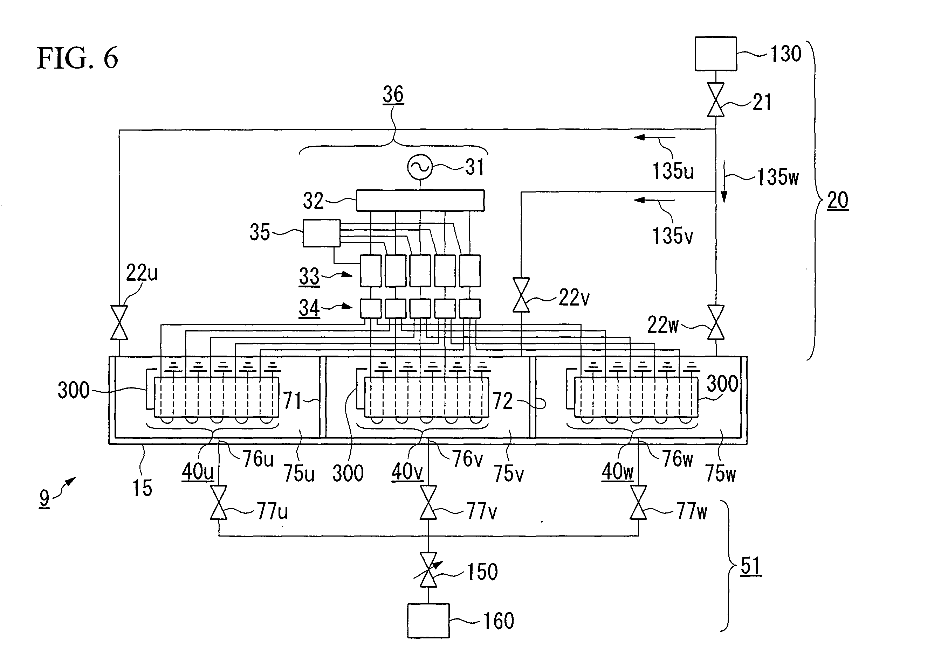

FIG. 6 is a diagram showing an important portion of the thin film forming system according to a fifth embodiment of the present invention. That is, the important portion indicates the thin film forming device 9 (adjusting device) (9p, 9n), which is disposed in the thin film forming system 1, in place of the thin film forming devices 5p, 5n, shown in FIG. 1. The rest of the elements consisting of the thin film forming system 1 are the same as those described with respect to embodiment 1. In the present embodiment, the structures same as those shown in FIGS. 1 to 5 are not explained; therefore, only different structures are explained. Also, the substrates 300 are disposed perpendicularly to the plane of FIG. 6 as similarly to in FIG. 1. However, in FIG. 6, for better understanding the operation of the thin film forming system, the substrates are disposed horizontally to the plane of the drawing.

As shown in FIG. 5, the thin film forming device 9 (9p, 9n) consists of the same elements as those of the thin film forming device 7 shown in FIG. 4 except for separating walls 71 and 72, and the pumping system (pumping section) 51 (51p, 51n). The same reference symbols are added to the same elements.

The separating walls 71 and 72 are disposed so as to separate the thin film forming regions 17u and 17v, and the thin film forming regions 17v and 17w respectively. Accordingly, each one of the thin film forming regions 17u, 17v, and 17w forms each one of the independent spaces 75u, 75v, and 75w respectively. Each one of pumping ports 76u, 76v, and 76w is disposed to each one of the independent spaces 76u, 76v, and 76w respectively.

The pumping system 51 (51p, 51n) consists of, pumping block valves 77u, 77v, and 77w, the pressure adjusting valve 150 (150p, 150n), and the vacuum pump 160 (160p, 160n) such that the gases, unnecessary for forming the thin films, are pumped from the pumping ports 76u, 76v, and 76w collectively.

With respect to the thin film forming system having the above structures, a case, in which the thin films are formed in the thin film forming region 75u first in the chamber 15p (15) in the thin film forming device 9p (9), is explained.

First, the selectors 34 select the array-antenna 40u from the array-antennas 40u, 40v, and 40w, and connect the circulators 33 and the array-antenna 40u. Also, among the pumping block valves 77u, 77v, and 77w, only the pumping block valve 77u is opened. The material gas 135u (135) is supplied to only the independent space 75u from the gas box 130 by opening the material gas supply valve 21 and the material gas distributing supply valve 22u. A pressure in the chamber 15p (15) is adjusted by the pressure adjusting valve 150p. The electric power is supplied from the high frequency power supply 31 to the array-antenna 40u via the divider 32, the circulators 33, and the selectors 34. The material gas 135u is plasmatized by the electric power supplied to the array-antenna 40u. The material gas in plasma state excited and decomposed to be a precursor. The precursors are deposited on the substrates 300 by surface reaction in the independent space 75u; thus, the p-type semiconductor thin films are formed on the substrates 300.

Because the independent space 75u is sealed by the separating wall 71, the material gases 135, excited and decomposed in the independent space 75u, do not disperse into the independent spaces 75v and 75w. Also, the gas unnecessary for forming the thin films is pumped from the pumping port 76u; thus, the unnecessary gas does not enter the independent spaces 75v and 75w.

Also, because only the pumping block valve 77u is opened while the pumping block valves 77v and 77w are closed, the gas, pumped from the independent space 75u and unnecessary for forming the thin films, does not enter the independent spaces 75v and 75w from the pumping block valves 77v and 77w. Thus, the unnecessary gas is pumped from the vacuum pump (160) 160p.

Next, the thin films are formed in the independent space 75u. The selectors 34 select the array-antenna 40v, and connect the circulators 33 and the array-antenna 40u. Among the pumping block valves 77u, 77v, and 77w, only the pumping block valve 77v is opened. Accordingly, the material gases 135v (135) are supplied from the gas box 130 to only the independent space 75 by opening the material gas supply valve 21 and the material gas distributing supply valve 22. By doing this, the p-type semiconductor thin films are formed on the substrates 300 similarly to when forming the thin films in the above explained independent space 75u.

Because the independent space 75v is sealed by the separating walls 71 and 72, the material gases 135, excited and decomposed in the independent space 75v, do not disperse into the independent spaces 75u and 75w. Also, the gas unnecessary for forming the thin films is pumped from the pumping port 76v; thus, the unnecessary gas does not enter the independent spaces 75u and 75w.

Also, because only the pumping block valve 77v is opened while the pumping block valves 77u and 77w are closed, the gas, pumped from the independent space 75v and unnecessary for forming the thin films, does not enter the independent spaces 75u and 75w from the pumping block valves 77u and 77w. Thus, the unnecessary gas is pumped from the vacuum pump (160) 160p.

Similarly, the gases 135 are prevented from diffusing from the independent space 75w to the independent spaces 75u and 75v by the separating wall 72. Also, while the unnecessary gases are pumped by opening and closing the pumping block valves 77u, 77v, and 77w, the p-type semiconductor thin films are formed on all of the substrates 300, disposed in each one of the independent spaces 75u, 75v, and 75w, in the thin film forming device 9p (9). By doing this, the formation of the thin films by the thin film forming device 9p (9) is completed.

In this case, the thin films are formed, in order, in each one of the thin film forming regions 75u, 75v, and 75w. Note that the present invention is not limited to the above order. That is, the order can be set desirably.

Also, because each one of the pumping block valves 77u, 77v, and 77w is disposed in each one of the independent spaces 75u, 75v, and 75w, the gases, i.e., the material gases 135, in any one of the independent spaces are pumped by opening one of the pumping block valves 77u, 77v, and 77w selectively. Also, by closing one of the pumping block valves 77u, 77v, and 77w selectively, air inside one of the desirable independent spaces can be evacuated.

For example, if the independent space 75v is not operable, and maintenance is necessary, the inoperable independent space 75v can be repaired under an atmospheric condition, by closing the pumping block valve 77v, while the rest of the independent spaces are under a vacuum condition.

Also, similarly to in the above explained thin film forming device 9p, the separating walls 71 and 72 and the pumping system 51 are disposed in the thin film forming device 9n. The material gases 135 are prevented from diffusing by the separating walls 71 and 72. Also, the gases unnecessary for forming the thin films are pumped by opening and closing the pumping block valves 77u, 77v, and 77w; thus, the n-type semiconductor thin films are formed on all of the substrates 300 disposed in each one of the independent spaces 75u, 75v, and 75w in the thin film forming device 9n (9). By doing this, the formation of the thin films in the thin film forming device 9n (9) is completed.

As explained above, the separating walls 71 and 72 separate the independent spaces 75u, 75v, and 75w, in the thin film forming device 9 (9p, 9n). Therefore, the material gas, excited and decomposed in one of the thin film forming regions, is prevented from diffusing to another one of the thin film forming regions. Therefore, the formation of the thin films on the substrates 300, disposed in another one of the thin film forming regions, can be prevented. Also, when the gases, unnecessary for forming the thin films in each one of the independent spaces, are pumped via the pumping ports and the pumping block valves, the pumping block valves in the other independent spaces are closed. By doing this, it is possible to prevent the gases, unnecessary for forming the thin films, from entering the other independent spaces.

Compounds which deteriorate the solar cells are reduced because the thin films are formed in each of the independent spaces. Therefore, the substrates 300 have desirable thin films and desirable surface quality.

Also, the gases, i.e., the material gases 135, etc., in any desirable one of the independent spaces can be pumped while each one of the pumping block valves 77u, 77v, and 77v is opened and closed selectively. Also, it is possible to evacuate the air in any desirable one of the independent spaces.

For example, when the independent space 75v must be repaired because of inoperability, the inoperable independent space 75v can be repaired under an atmospheric condition, by closing the pumping block valve 77v disposed in the inoperable independent space 75v, while the rest of the independent spaces are under a vacuum condition.

### (Embodiment 6)

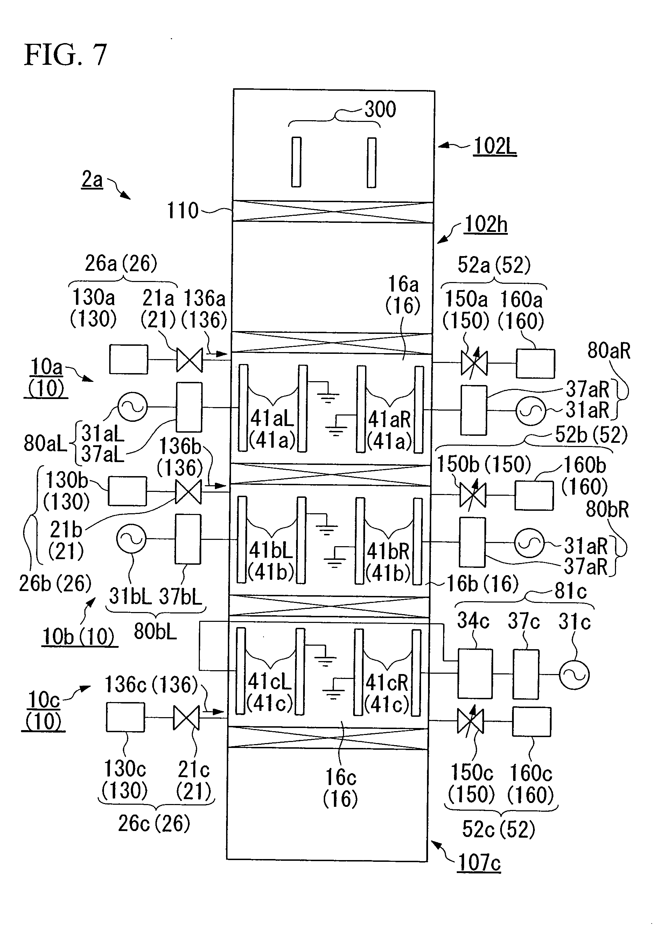

FIG. 7 is a diagram showing the thin film forming system, i.e., a thin film forming device for forming TFTs (thin film transistors), according to a sixth embodiment of the present invention. As shown in FIG. 7, the thin film forming system has the same structure as the thin film forming system 1 shown in FIG. 1 except for a thin film forming device 10 (10a, 10b, and 10c). The same reference symbols are added to the same elements. The substrates 300, to which the thin films are formed in the present embodiment, are disposed perpendicularly to the plane of FIG. 7.

As shown in FIG. 7, a thin film forming system 2a consists of, SiN thin film forming device 10a, an i-type amorphous Si thin film forming device (reference device) 10b, and an n+ amorphous Si thin film forming device (adjusting device) 10c.

Each one of the thin film forming devices 10 (10a, 10b, and 10c) consists of, each one of chambers 16 (16a, 16b, and 16c), each one of gas supply systems 26 (26a, 26b, and 26c), each one of the pumping systems 52 (52a, 52b, and 52c), a substrate importing section (importing section) not shown in the drawings, and a substrate exporting section (exporting section) not shown in the drawings. Power supply systems 80a (80aL, 80aR) and 80b (80bL, 80bR) are disposed in each one of the thin film forming devices 10a and 10b. A power supply system 80c is disposed in the thin film forming device 10c.

The chambers 16 (16a, 16b, and 16c) are vacuum chambers for forming the thin films on the substrates 300.

Each one of gas supply systems 26 (26a, 26b, and 26c) consists of, one of the gas boxes 130 (130a, 130b, and 130c) for supplying material gases 136 (136a, 136b, and 136c), and one of the material gas supply valves 21 (21a, 21b, and 21c) for supplying the material gases 136 (136a, 136b, and 136c) to the chambers 16 (16a, 16b, and 16c).

Each one of the pumping systems 52 (52a, 52b, and 52c) consists of, one of the pressure adjusting valves 150 (150a, 150b, and 150c), and one of the vacuum pumps 160 (160a, 160b, and 160c).

Each one of the power supply systems 80aL, 80aR, 80bL, and 80bR consists of, one of the high frequency power supplies 31 (31aL, 31aR, 31bL, and 31bR), one of the matching boxes 37 (37aL, 37aR, 37bL, and 37bR), and one of the parallel plate electrodes 41 a, 41b, (41aL, 41aR, 41bL, and 41bR) respectively.

Also, the power supply system 81c consists of a high frequency power supply 31c, a matching box 37c, parallel plate electrodes 41c (41cL, 41cR), and a selector 34c. The selector 34c selects one of the parallel plate electrodes 41cL or 41cR so as to supply the electric power from the high frequency power supply 31c to the selected parallel plate electrode 41c.

Also, in the thin film forming system 2a according to the present embodiment, operation of the thin film forming device 10c for forming the n+ amorphous Si thin films is adjusted in accordance with operation of the thin film forming device 10b for forming the i-type amorphous Si thin films, the time for forming the i-type amorphous Si thin films being the longest among the SiN thin films, the i-type amorphous Si thin films, and the n+ amorphous Si thin films.

More specifically, by adjusting an operation status of the selector 34c or the gas supply system 26c in the thin film forming device 10c, the cost of the power supply system 81c, the material gases 136c, or the like, is reduced, and the cost of the thin film forming system is determined. Also, processing capacity in the thin film forming system is determined based on the time for forming the thin films in the thin film forming device 10c or 10b. Operation of the selector 34c or the gas supply system 26c is adjusted such that production cost of the thin film forming system, with respect to time and area, is moved toward a minimum, the time and the area being calculated based on the cost of the device, and the processing capacity thereof.

Also, the operation of the selector 34c or the gas supply system 26c is adjusted. By doing this, a power supply system 81c having desirable power capacity and a vacuum pump 160c having desirable pumping speed are employed.

In the thin film forming system 2a having the above structure, the transporting devices (transporting system), not shown in the drawings, transport 2 (two) pieces of substrate 300 to the load-lock device 102L under an atmospheric condition, and after that, pressure around the substrates 300 is decompressed until all the air in the load-lock device 102L is evacuated.

After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h.

The substrates 300, disposed in the heating device 102h, are heated to a predetermined temperature by the heating device 102h.

Next, the gate valve 110, disposed between the heating device 102h and the thin film forming device 10a, opens, and the transporting devices, not shown in the drawing, transport the substrates 300 from the heating device 102h to the substrate importing section in the thin film forming device 10a; thus, the substrates 300 are disposed in each one of the parallel plate electrodes 41aL and 41aR.

An inside of the chamber 16a is maintained under a vacuum condition by the vacuum pump 160a so as to be ready to start forming the thin films on the substrates 300.

The material gas 136a is supplied from the gas box 130a to the chamber 16a by opening the material gas supply valve 21a. A pressure inside the chamber 16a is adjusted by the pressure adjusting valve 150a. The electric power is supplied from the high frequency power supplies 31aL, 31aR to the parallel plate electrodes 41aL and 41aR via the matching boxes 37aL and 37aR simultaneously. The material gas 136a is plasmatized by the electric power supplied to the parallel plate electrodes 41aL and 41aR. The material gas in plasma state excited and decomposed to be a precursor. The precursors are deposited on the substrates 300 by surface reaction in the thin film forming device 10a. Thus, SiN thin films are formed on two pieces of the substrates 300 simultaneously. Unnecessary gas generated in the above operation for forming the thin films is pumped by the vacuum pump 160a.

Next, the gate valve 110, disposed between the thin film forming devices 10a and 10b, opens, and the transporting devices, not shown in the drawing, transport the substrates 300 from the substrate exporting section in the thin film forming device 10a to the substrate importing section in the thin film forming device 10b; thus, the substrates 300 are disposed in each one of the parallel plate electrodes 41bL and 41bR in the chamber 16b.

In the thin film forming device 10a, the substrates 300, on which the thin films are formed in each one of the parallel plate electrodes, are not transported to different parallel plate electrodes, in which different thin films are formed. For example, the substrates 300 are not transported to the parallel plate electrode 41aL after the thin films are formed on the substrates 300 by the parallel plate electrode 41aR.

An inside of the thin film forming device 10b is maintained under a vacuum condition by the vacuum pump 160b so as to be ready to start forming the thin films on the substrates 300.

The material gas 136b is supplied from the gas box 130b to the chamber 16b by opening the material gas supply valve 21b. A pressure inside the chamber 16b is adjusted by the pressure adjusting valve 150b. The electric power is supplied from the high frequency power supplies 31bL, 31bR to the parallel plate electrodes 41bL and 41bR via the matching boxes 37bL and 37bR simultaneously. The material gas 136b is plasmatized by the electric power supplied to the parallel plate electrodes 41bL and 41bR. The material gas in plasma state excited and decomposed to be a precursor. The precursors are deposited on the substrates 300 by surface reaction in the thin film forming device 10b. Thus, the i-type amorphous Si thin films are formed on two pieces of the substrates 300 simultaneously. Unnecessary gas generated in the above operation for forming the thin films is pumped by the vacuum pump 160b.

The operation for forming the i-type amorphous Si thin films is the throughput determining step in the thin film forming system 2a for producing the thin films for the TFTs.

The gate valve 110, disposed between the thin film forming devices 10b and 10c, opens, and the transporting devices, not shown in the drawings, transport the substrates 300 from the substrate exporting section in the thin film forming device 10b to the substrate importing section in the thin film forming device 10c; thus, the substrates 300 are disposed in each one of the parallel plate electrodes 41cL and 41cR in the chamber 16c.

In the thin film forming device 10b, the substrates 300, on which the thin films are formed in each one of the parallel plate electrodes, are not transported to different parallel plate electrodes, in which different thin films are formed. For example, the substrates 300 are not transported to the parallel plate electrode 41bL after the thin films are formed on the substrates 300 by the parallel plate electrode 41bR.

An inside of the thin film forming device 10c is maintained under a vacuum condition by the vacuum pump 160c so as to be ready to start forming the thin films on the substrates 300.

Next, a case, in which, the selector 34c selects the parallel plate electrode 41cR first, and the thin films are formed in the thin film forming device 10c, is explained.

First, the selector 34c selects the parallel plate electrode 41cR such that the matching box 37c and the parallel plate electrode 41cR are connected. The material gas 136c is supplied from the gas box 130c to the chamber 16c by opening the material gas supply valve 21c. A pressure inside the chamber 16c is adjusted by the pressure adjusting valve 150c. The electric power is supplied from the high frequency power supply 31c to the parallel plate electrode 41 cR via the matching box 37c. The material gas 136c is plasmatized by the electric power supplied to the parallel plate electrode 41cR. The material gas in plasma state excited and decomposed to be a precursor. The precursors are deposited on the substrates 300 by surface reaction, the n+ amorphous Si thin films are formed on the substrates 300.

Unnecessary gas generated in the above operation for forming the thin films is pumped by the vacuum pump (160) 160c.

Next, the selector 34c selects the parallel plate electrode 41cL such that the matching box 37c and the parallel plate electrode 41cL are connected. Similarly to in the parallel plate electrode 41cR, the material gas 136c is excited and decomposed; thus, the n+ amorphous Si thin films are formed on the substrates 300.

In this case, the thin films are formed, in order, in each one of the parallel plate electrodes 41cR and 41cL. Note that the present invention is not limited to the above order. That is, the order can be set desirably.

In the above operations for forming the thin films, any one of SiN thin films, i-type amorphous Si thin films, and n+ amorphous Si thin films can be selectively disposed by changing the material gas 136 (136a, 136b, and 136c), which is supplied to each one of the thin film forming devices 10a, 10b, and 10c. By layering the semiconductor thin films in the above manner, the TFT thin films are formed.

After the SiN thin films, the i-type amorphous Si thin films, and the n+ amorphous Si thin films are formed on the substrates 300, the gate valve 110, disposed between the thin film forming device 10c and the cooling device 107c, opens, and the transporting devices, not shown in the drawings, transport the substrates 300 from the substrate exporting section in the thin film forming device 10c to the cooling device 107c; thus, the substrates 300 are disposed in the cooling device 107c.

In the thin film forming device 10c, the substrates 300, on which the thin films are formed in each one of the parallel plate electrodes, are not transported to different parallel plate electrodes, in which different thin films are formed. For example, the substrates 300 are not transported to the parallel plate electrode 41cL after the thin films are formed on the substrates 300 by the parallel plate electrode 41cR.

The substrates 300 disposed in the cooling device 107c are cooled to a predetermined temperature, and after that, the transporting devices, not shown in the drawings, transport the substrates 300 to an unload-lock chamber, not shown in the drawing. Pressure in a vacuum space in the unload-lock chamber is pressurized to atmospheric pressure.

As explained above, the thin films are formed in one of the parallel plate electrodes 41cR or 41cL, selected by the selector 34c. In addition the thin films are formed by selecting the parallel plate electrodes further. Therefore, a single high frequency power supply for supplying the electric power to the parallel plate electrodes 41cR and 41cL is not necessary. Accordingly, the power supply system can be simplified, the cost of the thin film forming device can be reduced, and the cost of an entire thin film forming system can be reduced.

Also, the operation of the thin film forming device 10c is adjusted in accordance with the time for forming the thin films in the thin film forming device 10b. The thin films are formed in one of the parallel plate electrodes selected by the selector 34c step by step. Therefore, the thin films can be formed without reducing a total efficiency of the thin film forming system 2a.

In addition, with respect to time and conditions for forming various and desirable TFT thin films, power supply systems, having desirable power capacity, and pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 10a, 10b, and 10c. After the formation of the thin films thereon, the substrates 300 are transported by the substrate exporting section different from the substrate importing section. Therefore, the transportation of the substrates is not reciprocal; thus, the substrate having the thin films can be transported efficiently.

In the present embodiment, various operations are conducted while 2 (two) pieces of the substrates 300 are transported into the thin film forming system 2a. However, the quantity of the substrates is not limited to two pieces. That is, the quantity of the substrates can be set desirably.

### (Embodiment 7)

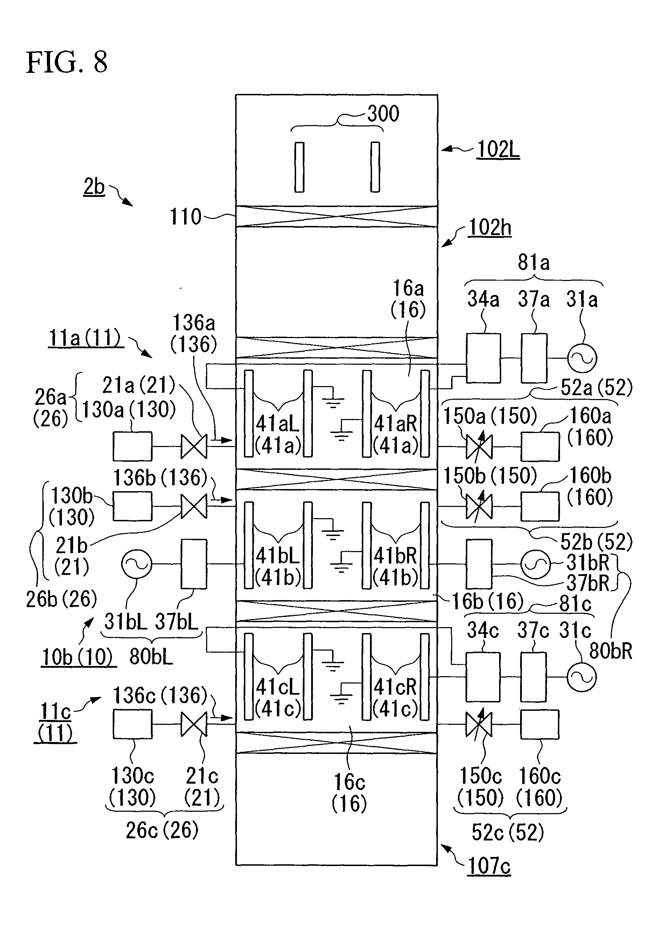

FIG. 8 is a diagram showing the thin film forming system, i.e., a thin film forming device for forming TFTs, according to a seventh embodiment of the present invention. As shown in FIG. 8, the thin film forming system has the same structure as the thin film forming system 2a shown in FIG. 7 except for a thin film forming device 11 (11a, 11c) The same reference symbols are added to the same elements. The substrates 300, which the thin films are formed in the present embodiment, are disposed perpendicularly to the plane of FIG. 7.

As shown in FIG. 8, a thin film forming system 2b consists of, an SiN thin film forming device (adjusting device) 11a, and an n+ amorphous Si thin film forming device (adjusting device) 11c, in place of the thin film forming devices 10a and 10c.

Each of the thin film forming devices 11 (11a, 11c) has the same structure as the thin film forming devices 10 (10a, 10c) shown in FIG. 7 except a power supply system 81 (81a, 81c). The same reference symbols are added to the same elements.

Each one of the power supply systems 81 (81a, 81c) consists of, one of the high frequency power supplies 31a and 31c, one of the matching boxes 37a and 37c, one of the parallel plate electrodes 41a and 41c (41aL, 41aR, 41bL, and 41cR), and one of the selectors 34a and 34c. The selectors 34 (34a, 34c) select one of the parallel plate electrodes 41L (41aL, 41bL) or 41R (41aR, 41bR) so as to supply the electric power from the high frequency power supplies 31a and 31c to the selected parallel plate electrodes 41a and 41c.

Also, in the thin film forming system 2b according to the present embodiment, operations of the thin film forming devices 11a and 11c for forming the SiN thin films and the n+ amorphous Si thin films are adjusted in accordance with operation of the thin film forming device 10b for forming the i-type amorphous Si thin films, the time for forming the i-type amorphous Si thin films being the longest among the SiN thin films, the i-type amorphous Si thin films, and the n+ amorphous Si thin films. Details thereof are the same as those explained in embodiment 6.

In the thin film forming system 2b having the above structure, the transporting devices (transporting system), not shown in the drawings, transport 2 (two) pieces of substrate 300 to the load-lock device 102L under an atmospheric condition, and after that, an pressure around the substrates 300 is decompressed until all the air in the load-lock device 102L is evacuated.

After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h.

The substrates 300, disposed in the heating device 102h, are heated to a predetermined temperature by the heating device 102h.

Next, the gate valve 110, disposed between the heating device 102h and the thin film forming device 11a, opens, and the transporting devices, not shown in the drawing, transport the substrates 300 from the heating device 102h to the substrate importing section in the thin film forming device 11a; thus, the substrates 300 are disposed in each one of the parallel plate electrodes 41aL and 41aR.

An inside of the chamber 16a is maintained under a vacuum condition by the vacuum pump 160a so as to be ready to start forming the thin films on the substrates 300.

Next, a case, in which the selector 34a selects the parallel plate electrode 41aR first, and the thin films are formed in the thin film forming device 11a, is explained.

First, the selector 34a selects the parallel plate electrode 41aR such that the matching box 37a and the parallel plate electrode 41aR are connected. The material gas 136a is supplied from the gas box 130a to the chamber 16a by opening the material gas supply valve 21a. A pressure inside the chamber 16a is adjusted by the pressure adjusting valve 150a. The electric power is supplied from the high frequency power supply 31a to the parallel plate electrode 41aR via the matching box 37a. The material gas 136a is plasmatized by the electric power supplied to the parallel plate electrode 41aR. The material gas in plasma state excited and decomposed to be a precursor. The precursors are deposited on the substrates 300 by surface reaction, the SiN thin films are formed on the substrates 300.

Unnecessary gas generated in the above operation for forming the thin films is pumped by the vacuum pump (160) 160a.

Next, the selector 34a selects the parallel plate electrode 41aL such that the matching box 37a and the parallel plate electrode 41aL are connected. Similarly to in the parallel plate electrode 41aR, the material gas 136a is excited and decomposed; thus, the SiN thin films are formed on the substrates 300.

In this case, the thin films are formed, in order, in each one of the parallel plate electrodes 41aR and 41aL. Note that the present invention is not limited to the above order. That is, the order can be set desirably.

Next, the gate valve 110, disposed between the thin film forming devices 11a and 10b, opens, and the transporting devices, not shown in the drawing, transport the substrates 300 from the substrate exporting section in the thin film forming device 11a to the substrate importing section in the thin film forming device 10b; thus, the substrates 300 are disposed in each one of the parallel plate electrodes 41bL and 41bR in the chamber 16b.

In the thin film forming device 11a, the substrates 300, on which the thin films are formed in each one of the parallel plate electrodes, are not transported to different parallel plate electrodes, in which different thin films are formed. For example, the substrates 300 are not transported to the parallel plate electrode 41aL after the thin films are formed on the substrates 300 by the parallel plate electrode 41aR.

An inside of the thin film forming device 10b is maintained under a vacuum condition by the vacuum pump 160b so as to be ready to start forming the thin films on the substrates 300.

The material gas 136b is supplied from the gas box 130b to the chamber 16b by opening the material gas supply valve 21b. A pressure inside the chamber 16b is adjusted by the pressure adjusting valve 150b. The electric power is supplied from the high frequency power supplies 31bL, 31bR to the parallel plate electrodes 41bL and 41bR via the matching boxes 37bL and 37bR simultaneously. The material gas 136b is plasmatized by the electric power supplied to the parallel plate electrodes 41bL and 41bR. The material gas in plasma state excited and decomposed to be a precursor. The precursors are deposited on the substrates 300 by surface reaction in the thin film forming device 10b. Thus, the i-type amorphous Si thin films are formed on two pieces of the substrates 300 simultaneously. Unnecessary gas generated in the above operation for forming the thin films is pumped by the vacuum pump 160b.

The operation for forming the i-type amorphous Si thin films is the throughput determining step in the thin film forming system 2b for producing the thin films for the TFTs.

The gate valve 110, disposed between the thin film forming devices 10b and 11c, opens, and the transporting devices, not shown in the drawings, transport the substrates 300 from the substrate exporting section in the thin film forming device 10b to the substrate importing section in the thin film forming device 11c; thus, the substrates 300 are disposed in each one of the parallel plate electrodes 41cL and 41cR in the chamber 16c.

In the thin film forming device 10b, the substrates 300, on which the thin films are formed in each one of the parallel plate electrodes, are not transported to different parallel plate electrodes, in which different thin films are formed. For example, the substrates 300 are not transported to the parallel plate electrode 41bL after the thin films are formed on the substrates 300 by the parallel plate electrode 41bR.

An inside of the thin film forming device 11c is maintained under a vacuum condition by the vacuum pump 160c so as to be ready to start forming the thin films on the substrates 300.

Next, a case, in which, the selector 34c selects the parallel plate electrode 41cR first, and the thin films are formed in the thin film forming device 11c, is explained.

First, the selector 34c selects the parallel plate electrode 41 cR such that the matching box 37c and the parallel plate electrode 41cR are connected. The material gas 136c is supplied from the gas box 130c to the chamber 16c by opening the material gas supply valve 21c. A pressure inside the chamber 16c is adjusted by the pressure adjusting valve 150c. The electric power is supplied from the high frequency power supply 31c to the parallel plate electrode 41cR via the matching box 37c. The material gas 136c is plasmatized by the electric power supplied to the parallel plate electrode 41cR. The material gas in plasma state excited and decomposed to be a precursor. The precursors are deposited on the substrates 300 by surface reaction, the n+ amorphous Si thin films are formed on the substrates 300.

Unnecessary gas generated in the above operation for forming the thin films is pumped by the vacuum pump (160) 160c.

Next, the selector 34c selects the parallel plate electrode 41cL such that the matching box 37c and the parallel plate electrode 41cL are connected. Similarly to in the parallel plate electrode 41cR, the material gas 136c is excited and decomposed; thus, the n+ amorphous Si thin films are formed on the substrates 300.

In this case, the thin films are formed, in order, in each one of the parallel plate electrodes 41cR and 41cL. Note that the present invention is not limited to the above order. That is, the order can be set desirably.

In the above operations for forming the thin films, any one of SiN thin films, i-type amorphous Si thin films, and n+ amorphous Si thin films can be selectively disposed by changing the material gas 136 (136a, 136b, and 136c), which is supplied to each one of the thin film forming devices 11a, 10b, and 11c. By layering the semiconductor thin films in the above manner, the TFT thin films are formed.

After the SiN thin films, the i-type amorphous Si thin films, and the n+ amorphous Si thin films are formed on the substrates 300, the gate valve 110, disposed between the thin film forming device 11c and the cooling device 107c, opens, and the transporting devices, not shown in the drawings, transport the substrates 300 from the substrate exporting section in the thin film forming device 11c to the cooling device 107c; thus, the substrates 300 are disposed in the cooling device 107c.

In the thin film forming device 11c, the substrates 300, on which the thin films are formed in each one of the parallel plate electrodes, are not transported to different parallel plate electrodes, in which different thin films are formed. For example, the substrates 300 are not transported to the parallel plate electrode 41cL after the thin films are formed on the substrates 300 by the parallel plate electrode 41cR.

The substrates 300 disposed in the cooling device 107c are cooled to a predetermined temperature, and after that, the transporting devices, not shown in the drawings, transport the substrates 300 to an unload-lock chamber, not shown in the drawing. Pressure in a vacuum space in the unload-lock chamber is pressurized to atmospheric pressure.

As explained above, the thin films are formed in one of the parallel plate electrodes, selected by the selectors 34a and 34c in the thin film forming system 2b. In addition, the thin films are formed by selecting the parallel plate electrodes further. Therefore, a single high frequency power supply for supplying the electric power to the parallel plate electrodes 41aR and 41aL is not necessary. Accordingly, the power supply system can be simplified, the cost of the thin film forming device can be reduced, and the cost of an entire thin film forming system can be reduced more than the thin film forming system 2a.

Also, similarly to in the above explained embodiment 6, the operations of the thin film forming devices 11a and 11c are adjusted in accordance with the time for forming the thin films in the thin film forming device 10b. The thin films are formed in one of the parallel plate electrodes, selected by the selectors 34a and 34c step by step. Therefore, the thin films can be formed without reducing a total efficiency of the thin film forming system 2b.

In addition, similar to in the above embodiments, with respect to time and conditions for forming various and desirable TFT thin films, power supply systems, having desirable power capacity, and pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 11a, 10b, and 11c. After the formation of the thin films thereon, the substrates 300 are transported by the substrate exporting section different from the substrate importing section. Therefore, the transportation of the substrates is not reciprocal; thus, the substrate having the thin films can be transported efficiently.

### (Embodiment 8)

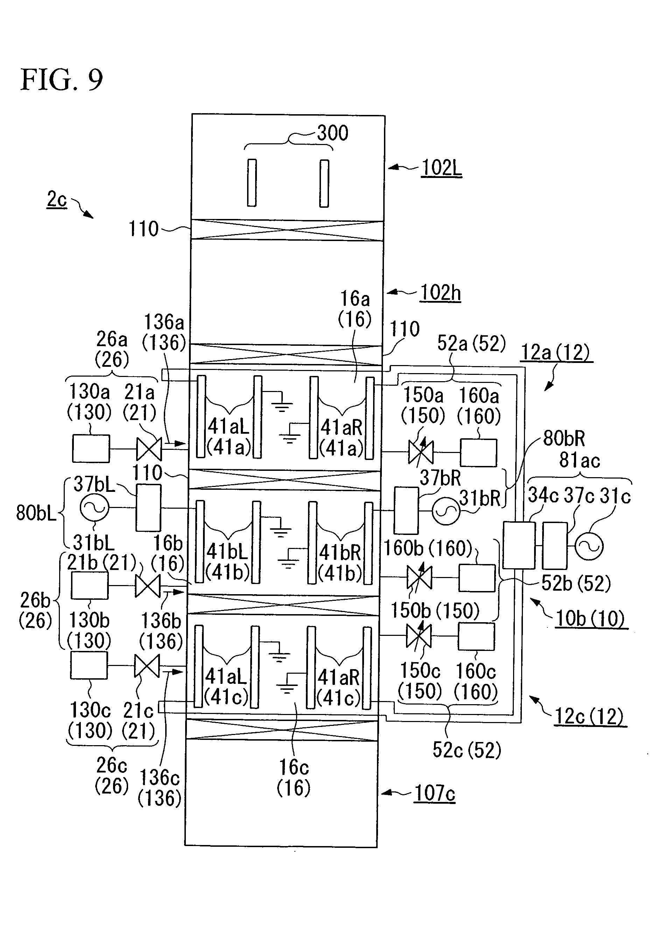

FIG. 9 is a diagram showing the thin film forming system, i.e., a thin film forming device for forming TFTs, according to an eighth embodiment of the present invention. As shown in FIG. 9, the thin film forming system has the same structure as the thin film forming system 2a shown in FIG. 7 except for a thin film forming device 12 (12a, 12c) Same reference symbols are added to the same elements. The substrates 300, on which the thin films are formed in the present embodiment, are disposed perpendicularly to the plane of FIG. 9.

As shown in FIG. 9, a thin film forming system 2c consists of, an SiN thin film forming device (adjusting device) 12a, and an n+ amorphous Si thin film forming device (adjusting device) 12c, in place of the thin film forming devices 10a and 10c.

Each of the thin film forming devices 12 (12a, 12c) has the same structure as the thin film forming devices 10 (10a, 10c) shown in FIG. 7 except for a power supply system 81ac. The same reference symbols are added to the same elements.

The power supply system 81ac, consisting of, a high frequency power supply 31 ac, a matching box 37ac, a selector 34ac, and parallel plate electrodes 41a, 41c (41aL, 41aR, 41cL, and 41cR), is disposed as a common power supply system to the thin film forming devices 12 (12a, 12c). The selector 34ac selects one of the parallel plate electrodes so as to supply the electric power from the high frequency power supply 31 ac to the parallel plate electrode, selected by the selector 34ac.

Also, in the thin film forming system 2c according to the present embodiment, operations of the thin film forming devices 12a and 12c for forming the SiN thin films and the n+ amorphous Si thin films are adjusted in accordance with operation of the thin film forming device 10b for forming the i-type amorphous Si thin films, the time for forming the i-type amorphous Si thin films being the longest among the SiN thin films, the i-type amorphous Si thin films, and the n+ amorphous Si thin films. The details thereof are the same as those explained for embodiment 6.

In the thin film forming system 2c having the above structure, the transporting devices (transporting system), not shown in the drawings, transport 2 (two) pieces of substrates 300 to the load-lock device 102L under an atmospheric condition, and after that, pressure around the substrates 300 is decompressed until all the air in the load-lock device 102L is evacuated.

After that, the gate valve 110, disposed between the load-lock device 102L and the heating device 102h, opens, and the transporting devices, not shown in the drawing, transport the substrates 300 from the load-lock device 102L to the heating device 102h; thus, the substrates 300 are disposed in the heating device 102h.

The substrates 300, disposed in the heating device 102h, are heated to a predetermined temperature by the heating device 102h.

Next, the gate valve 110, disposed between the heating device 102h and the thin film forming device 12a, opens, and the transporting devices, not shown in the drawing, transport the substrates 300 from the heating device 102h to the substrate importing section in the thin film forming device 12a; thus, the substrates 300 are disposed in each one of the parallel plate electrodes 41aL and 41aR.

An inside of the chamber 16a is maintained under a vacuum condition by the vacuum pump 160a so as to be ready to start forming the thin films on the substrates 300.

Next, a case, in which, the selector 34ac selects the parallel plate electrode 41aR first, and the thin films are formed in the thin film forming device 12a, is explained.

First, the selector 34ac selects the parallel plate electrode 41 aR such that the matching box 37ac and the parallel plate electrode 41aR are connected. The material gases 136a is supplied from the gas box 130a to the chamber 16a by opening the material gas supply valve 21a. A pressure inside the chamber 16a is adjusted by the pressure adjusting valve 150a. The electric power is supplied from the high frequency power supply 31ac to the parallel plate electrode 41aR via the matching box 37ac. The material gas 136a is plasmatized by the electric power supplied to the parallel plate electrode 41aR. The material gas in plasma state excited and decomposed to be a precursor. The precursors are deposited on the substrates 300 by surface reaction, the SiN thin films are formed on the substrates 300.

Unnecessary gas generated in the above operation for forming the thin films is pumped by the vacuum pump (160) 160a.

Next, the selector 34ac selects the parallel plate electrode 41aL such that the matching box 37ac and the parallel plate electrode 41aL are connected. Similarly to the parallel plate electrode 41aR, the material gas 136a is excited and decomposed; thus, the SiN thin films are formed on the substrates 300.

In this case, the thin films are formed, in order, in each one of the parallel plate electrodes 41aR and 41aL. Note that the present invention is not limited to the above order. That is, the order can be set desirably.

Next, the gate valve 110, disposed between the thin film forming devices 12a and 10b, opens, and the transporting devices, not shown in the drawing, transport the substrates 300 from the substrate exporting section in the thin film forming device 12a to the substrate importing section in the thin film forming device 10b; thus, the substrates 300 are disposed in each one of the parallel plate electrodes 41bL and 41bR in the chamber 16b.

In the thin film forming device 12a, the substrates 300, on which the thin films are formed in each one of the parallel plate electrodes, are not transported to different parallel plate electrodes, in which different thin films are formed. For example, the substrates 300 are not transported to the parallel plate electrode 41aL after the thin films are formed on the substrates 300 by the parallel plate electrode 41aR.

An inside of the thin film forming device 10b is maintained under a vacuum condition by the vacuum pump 160b so as to be ready to start forming the thin films on the substrates 300.

The material gas 136b is supplied from the gas box 130b to the chamber 16b by opening the material gas supply valve 21b. A pressure inside the chamber 16b is adjusted by the pressure adjusting valve 150b. The electric power is supplied from the high frequency power supplies 31bL, 31bR to the parallel plate electrodes 41bL and 41bR via the matching boxes 37bL and 37bR simultaneously. The material gas 136b is plasmatized by the electric power supplied to the parallel plate electrodes 41bL and 41bR. The material gas in plasma state excited and decomposed to be a precursor. The precursors are deposited on the substrates 300 by surface reaction in the thin film forming device 10b. Thus, the i-type amorphous Si thin films are formed on the two pieces of substrate 300 simultaneously. Unnecessary gas generated in the above operation for forming the thin films is pumped by the vacuum pump 160b.

The operation for forming the i-type amorphous Si thin films is the throughput determining step in the thin film forming system 2c for producing the thin films for the TFTs.

The gate valve 110, disposed between the thin film forming devices 10b and 12c, opens, and the transporting devices, not shown in the drawings, transport the substrates 300 from the substrate exporting section in the thin film forming device 10b to the substrate importing section in the thin film forming device 12c; thus, the substrates 300 are disposed in each one of the parallel plate electrodes 41cL and 41cR in the chamber 16c.

In the thin film forming device 10b, the substrates 300, on which the thin films are formed in each one of the parallel plate electrodes, are not transported to different parallel plate electrodes, in which different thin films are formed. For example, the substrates 300 are not transported to the parallel plate electrode 41bL after the thin films are formed on the substrates 300 by the parallel plate electrode 41bR.

An inside of the thin film forming device 12c is maintained under a vacuum condition by the vacuum pump 160c so as to be ready to start forming the thin films on the substrates 300.

Next, a case, in which, the selector 34ac selects the parallel plate electrode 41cR first, and the thin films are formed in the thin film forming device 12c, is explained.

First, the selector 34ac selects the parallel plate electrode 41 cR such that the matching box 37ac and the parallel plate electrode 41cR are connected. The material gas 136c is supplied from the gas box 130c to the chamber 16c by opening the material gas supply valve 21c. A pressure inside the chamber 16c is adjusted by the pressure adjusting valve 150c. The electric power is supplied from the high frequency power supply 31ac to the parallel plate electrode 41 cR via the matching box 37ac. The material gas 136c is plasmatized by the electric power supplied to the parallel plate electrode 41 cR. The material gas in plasma state excited and decomposed to be a precursor. The precursors are deposited on the substrates 300 by surface reaction, the n+ amorphous Si thin films are formed on the substrates 300.

Unnecessary gas generated in the above operation for forming the thin films is pumped by the vacuum pump (160) 160c.

Next, the selector 34ac selects the parallel plate electrode 41 cL such that the matching box 37ac and the parallel plate electrode 41cL are connected. Similarly to in the parallel plate electrode 41cR, the material gas 136c is excited and decomposed; thus, the n+ amorphous Si thin films are formed on the substrates 300.

In this case, the thin films are formed, in order, in each one of the parallel plate electrodes 41cR and 41cL. Note that the present invention is not limited to the above order. That is, the order can be set desirably.

In the above operations for forming the thin films, any one of SiN thin films, i-type amorphous Si thin films, and n+ amorphous Si thin films can be selectively disposed by changing the material gas 136 (136a, 136b, and 136c), which is supplied to each one of the thin film forming devices 12a, 10b, and 12c. By layering the semiconductor thin films in the above manner, the TFT thin films are formed.

After the SiN thin films, the i-type amorphous Si thin films, and the n+ amorphous Si thin films are formed on the substrates 300, the gate valve 110, disposed between the thin film forming device 12c and the cooling device 107c, opens, and the transporting devices, not shown in the drawings, transport the substrates 300 from the substrate exporting section in the thin film forming device 12c to the cooling device 107c; thus, the substrates 300 are disposed in the cooling device 107c.

In the thin film forming device 12c, the substrates 300, on which the thin films are formed in each one of the parallel plate electrodes, are not transported to different parallel plate electrodes, in which different thin films are formed. For example, the substrates 300 are not transported to the parallel plate electrode 41cL after the thin films are formed on the substrates 300 by the parallel plate electrode 41cR.

The substrates 300 disposed in the cooling device 107c are cooled to a predetermined temperature, and after that, the transporting devices, not shown in the drawings, transport the substrates 300 to an unload-lock chamber. Pressure in a vacuum space in the unload-lock chamber is pressurized to atmospheric pressure.

As explained above, in the thin film forming system 2c, the thin films are formed in one of the thin film forming devices 12a and 12c having the parallel plate electrodes selected by the selector 34ac. In addition, the thin films are formed by selecting the parallel plate electrodes further. Therefore, one set of the high frequency power supply, for supplying the electric power to the parallel plate electrodes 41aR, 41aL, 41cR, and 41cL, can be reduced. Accordingly, the power supply system can be simplified, the cost of the thin film forming device can be reduced, and the cost of an entire thin film forming system can be reduced more than with the thin film forming system 2b.

Also, similarly to in the above explained embodiments 6 and 7, the operations of the thin film forming devices 12a and 12c are adjusted in accordance with the time for forming the thin films in the thin film forming device 10b. The thin films are formed in one of the parallel plate electrodes, selected by the selector 34ac step by step. Therefore, the thin films can be formed without deteriorating a total efficiency of the thin film forming system 2c.

In addition, similar to in the above embodiments, with respect to time and conditions for forming various and desirable TFT thin films, power supply systems, having desirable power capacity, and pumping systems, having desirable pumping speed, are employed. By doing this, the cost of the thin film forming device can be reduced. That is, the cost of an entire thin film forming system can be reduced.

Also, the substrates 300 are transported into the substrate importing section in each one of the thin film forming devices 12a, 10b, and 12c. After the formation of the thin films thereon, the substrates 300 are transported by the substrate exporting section different from the substrate importing section. Therefore, the transportation of the substrates is not reciprocal; thus, the substrate having the thin films can be transported efficiently.

### INDUSTRIAL APPLICABILITY

As explained above, the size of the vacuum pump can be reduced because it is possible to reduce an amount of the necessary material gas. Also, the power supply system can be simplified, the cost of the thin film forming device can be reduced, that is, the cost of an entire thin film forming system can be reduced.

Also, there are effects in that the dispersion of the material gas from one thin film forming region to another can be prevented, and the formation of the thin films on the substrates disposed in the another thin film forming region can be prevented.

Also, there are effects in that, the dispersion of the material gases from one space to another can be prevented by the separating walls, and the entrance of the material gases for forming the thin films from one space to another can be prevented. Therefore, there is an effect in that, compounds which deteriorate the solar cells are reduced because the thin films are formed in each of the independent spaces, and therefore, the substrates 300 have desirable thin films and desirable surface quality.

Also, the material gas is pumped from any one of the independent spaces by opening and closing the pumping block valves. By doing this, the vacuum condition can be maintained therein. Therefore, there is an effect in that inoperable independent space can be repaired easily.

Also, there are provided the transporting systems for transporting the substrates to only one of the thin film forming regions and transporting the substrate from the chamber after the thin films are formed thereon. Therefore, there is an effect in that the substrates having the thin films can be transported efficiently. Also, the transporting systems transport the substrates into the importing sections and transport the substrates from the exporting sections after the formation of the thin films. Therefore, the substrates having the thin films and the substrates to which the thin films are about to be formed are not interchanged; thus, there is an effect in that the substrates having the thin films can be transported efficiently.

Also, the thin films are formed in accordance with the time for forming the thin films by the thin film forming device having the throughput determining step while the operation of the rest of the thin film forming devices is adjusted. Therefore, there is an effect in that the thin films can be formed without reducing the productivity in the entire thin film forming system.

In addition, desirable power supply systems and desirable pumping systems are employed for forming various desirable thin films. Therefore, there are effects in that the cost of the thin film forming devices can be reduced, that is, the cost of the entire thin film forming system can be reduced.

Also, the layered solar cells, made of the p-type, i-type, and n-type semiconductor thin films, are produced; therefore, there is an effect in that the desirable layered solar cells can be formed.

Also, the thin film transistors, made of the silicon nitride gate insulative thin films, i-type semiconductor thin films, and n-type semiconductor thin films, are produced; therefore, there is an effect in that the desirable thin film transistors can be formed.

## Claims

1. A thin film forming device for forming thin films on substrates disposed in chambers by plasma CVD method (Chemical Vapor Disposition method), comprising:
a plurality of thin film forming regions, disposed in the chambers, having electrodes for generating plasma;
a section for limiting the thin film forming regions in which electric power is supplied to at least one, but not all of the electrodes, simultaneously; and
gas supply systems for supplying material gases for producing plasma to the limited thin film forming regions.

2. A thin film forming device for forming thin films on substrates disposed in chambers by plasma CVD method (Chemical Vapor Disposition method), comprising:
a plurality of thin film forming regions, disposed in the chambers, having electrodes for generating plasma;
power supply systems for supplying electric power to the electrodes, the electric power being controlled to be supplied to at least one, but not all of the electrodes, the quantity of the power supply systems being less than the quantity of the thin film forming regions; and
switching devices for connecting the electrodes in each one of the thin film forming regions selectively to the power supply system.

3. A thin film forming device according to Claim 2, further comprising gas supply systems for limiting those of the thin film forming regions in which electric power is supplied to the electrodes, and supplying material gases for generating plasma to the limited thin film forming regions.

4. A thin film forming device according to Claim 2 or 3, wherein the electrodes are antennas for generating plasma.

5. A thin film forming device according to any one of Claims 1 to 4, wherein barrier plates are disposed on borders between the thin film forming regions, the barrier plates preventing the material gases from diffusing from one of the thin film forming regions in which the thin films are formed to another one of the thin film forming regions in which the thin films are not formed.

6. A thin film forming device according to any one of Claims 1 to 4, wherein the thin film forming regions are independent spaces sealed off from each other.

7. A thin film forming device according to any one of Claims 1 to 6, further comprising:
pumping sections for pumping the gases in the chambers, wherein the pumping sections are provided with pumping block valves for blocking the gas pumped from at least one of the thin film forming regions.

8. A thin film forming device according to any one of Claims 1 to 7, further comprising transporting systems for transporting the substrates into only one of the thin film forming regions and transporting the substrates from the thin film forming region after the formation of the thin films.

9. A thin film forming device according to any one of Claims 1 to 8, further comprising:
importing sections for transporting the substrates into the thin film forming region; and
exporting sections for transporting the substrates from the thin film forming region after the formation of the thin films, the exporting sections being different from the importing sections.

10. A method for forming thin films on substrates disposed in chambers by plasma CVD method (Chemical Vapor Disposition method), comprising:
selecting at least one, but not all of electrodes disposed in thin film forming regions by use of switching sections;
connecting the selected electrodes to power supply systems; and
supplying electric power from the power supply systems to the electrodes selected by using the switching sections.

11. A thin film forming method according to Claim 10, further comprising:
limiting the thin film forming regions in which electric power is supplied to the electrodes, and
supplying material gases for generating plasma to the limited thin film forming regions.

12. A thin film method according to Claim 10 or 11, further comprising:
transporting the substrates, imported from importing sections, to the thin film forming regions; and
transporting the substrates from exporting sections after formation of the thin films, the exporting sections being different from the importing sections.

13. A thin film forming system for layering thin films on a plurality of substrates, comprising:
a plurality of the thin film forming devices consisting of a reference device having the longest time for forming the thin films, and adjusting devices as the thin film forming device according to any one of Claims 1 to 8, the adjusting devices being different from the reference device.

14. A thin film forming system according to Claim 13, wherein the adjusting devices are operated in accordance with a time for forming the thin films in the reference device.

15. A thin film forming system according to Claim 13 or 14, wherein the adjusting device, the reference device, and another adjusting device are disposed in order, the p-type semiconductor thin films are formed by the adjusting device, the i-type semiconductor thin films are formed by the reference device, and the n-type semiconductor thin films are formed by the another adjusting device, so that a layered solar cell made of p-type, i-type, and n-type semiconductor thin films is formed.

16. A thin film forming system according to Claim 13 or 14, wherein the adjusting device, the reference device, and another adjusting device are disposed in this order in a direction of the substrates' transportation, the silicon nitride thin films are formed in the adjusting device, the i-type semiconductor thin films are formed in the reference device, and the n-type semiconductor thin films are formed by the another adjusting device, so that a thin film transistor including silicon nitride gate insulating thin films and thin film transistors made of i-type and n-type semiconductor thin films is formed.
